# EUROPEAN PATENT APPLICATION

(11) **EP 4 716 398 A1**
(43) Date of publication of application: **25.03.2026**
(21) Application number: 25202782.6
(22) Date of filing: 17.09.2025
(51) Int. Cl.: H10B 12/00

(54) **SEMICONDUCTOR DEVICE**

(30) Priority: 23.09.2024 KR 20240128447
(71) Applicant: Samsung Electronics Co., Ltd., Suwon-si, Gyeonggi-do 16677 (KR)
(72) Inventor: KIM, Taehyuk, 16677 Suwon-si, Gyeonggi-do (KR); KIM, Taekyong, 16677 Suwon-si, Gyeonggi-do (KR); ROH, Hyunah, 16677 Suwon-si, Gyeonggi-do (KR); PARK, Taejin, 16677 Suwon-si, Gyeonggi-do (KR); YANG, Hye Yeon, 16677 Suwon-si, Gyeonggi-do (KR); LEE, Hyeonkyu, 16677 Suwon-si, Gyeonggi-do (KR)
(74) Representative: Kuhnen & Wacker Patent- und Rechtsanwaltsbüro PartG mbB

(57) **Abstract**

A semiconductor device includes a cell vertical active pattern (21c) and a peripheral vertical active pattern at the same vertical level; a cell upper extended source/drain pattern (35c) and a cell contact plug (57c) sequentially stacked on the cell vertical active pattern (21c); a peripheral upper extended source/drain pattern (35n, 35p) and a peripheral contact plug (57n, 57p) sequentially stacked on the peripheral vertical active pattern; and an upper interconnection on the peripheral contact plug (57n, 57p) and the peripheral isolation pattern. A first distance between a vertical level of an upper end of the cell contact plug (57c) and a vertical level of an upper end of the cell isolation pattern (52a) is different from a second distance between a vertical level of an upper end of the peripheral contact plug (57n, 57p) and a vertical level of an upper end of the peripheral isolation pattern.

## Description

### BACKGROUND

Example embodiments of the present disclosure relate to a semiconductor device and a method of manufacturing the same.

Research into reducing a size of elements included in a semiconductor device and improving performance thereof has been conducted. For example, in a DRAM, research into reliably and stably forming components having a reduced size has been conducted, but as the size of components is reduced, dispersion properties of a semiconductor device have deteriorated.

### SUMMARY

Aspects of the inventive concept provide a semiconductor device having increased integration density and improved performance.

Aspects of the inventive concept provide a method of manufacturing the semiconductor device.

According to an example embodiment of the present disclosure, a semiconductor device includes a cell vertical active pattern and a peripheral vertical active pattern disposed at the same vertical level; a cell upper extended source/drain pattern and a cell contact plug sequentially stacked on the cell vertical active pattern; a peripheral upper extended source/drain pattern and a peripheral contact plug sequentially stacked on the peripheral vertical active pattern; a cell isolation pattern on a side surface of the cell upper extended source/drain pattern and a side surface of the cell contact plug; a peripheral isolation pattern on a side surface of the peripheral upper extended source/drain pattern and a side surface of the peripheral contact plug; and an upper interconnection on the peripheral contact plug and the peripheral isolation pattern, wherein a first distance between a vertical level of an upper end of the cell contact plug and a vertical level of an upper end of the cell isolation pattern is different from a second distance between a vertical level of an upper end of the peripheral contact plug and a vertical level of an upper end of the peripheral isolation pattern.

According to an example embodiment of the present disclosure, a semiconductor device includes a cell vertical active pattern and a peripheral vertical active pattern disposed at the same vertical level; a cell upper extended source/drain pattern and a cell contact plug sequentially stacked on the cell vertical active pattern; a peripheral upper extended source/drain pattern and a peripheral contact plug sequentially stacked on the peripheral vertical active pattern; a cell isolation pattern on a side surface of the cell upper extended source/drain pattern and a side surface of the cell contact plug; a peripheral isolation pattern on a side surface of the peripheral upper extended source/drain pattern and a side surface of the peripheral contact plug; and an upper interconnection on the peripheral contact plug and the peripheral isolation pattern, wherein the cell contact plug includes a cell lower conductive layer and a cell upper conductive layer sequentially stacked, wherein the peripheral contact plug includes a peripheral lower conductive layer and a peripheral upper conductive layer sequentially stacked, wherein the cell lower conductive layer and the peripheral lower conductive layer include a first conductive material, wherein the cell upper conductive layer and the peripheral upper conductive layer include a second conductive material different from the first conductive material, and wherein the upper interconnection includes a third conductive material different from the first conductive material and different from the second conductive material.

According to an example embodiment of the present disclosure, a semiconductor device includes a first structure including a memory region and a peripheral region; and a second structure vertically overlapping the first structure and including a peripheral circuit, wherein the memory region includes a cell vertical active pattern; a cell gate electrode having a side surface facing a side surface of the cell vertical active pattern; a cell upper source/drain pattern and a cell contact plug disposed on the cell vertical active pattern, the cell upper source/drain pattern being between the cell vertical active pattern and the cell contact plug; a cell isolation pattern on side surfaces of the cell upper source/drain pattern and the cell contact plug; and a data storage structure on the cell contact plug and the cell isolation pattern, wherein the peripheral region includes a peripheral vertical active pattern; a peripheral gate electrode having a side surface facing a side surface of the peripheral vertical active pattern; a peripheral upper source/drain pattern and a peripheral contact plug disposed on the peripheral vertical active pattern, the peripheral upper source/drain pattern being between the peripheral vertical active pattern and the peripheral contact plug; a peripheral isolation pattern on a side surface of the peripheral upper source/drain pattern and a side surface of the peripheral contact plug; and an upper interconnection on the peripheral contact plug and the peripheral isolation pattern, wherein the cell upper source/drain pattern includes a first cell source/drain layer and a second cell source/drain layer sequentially stacked, wherein the peripheral upper source/drain pattern includes a first peripheral source/drain layer and a second peripheral source/drain layer sequentially stacked, wherein the peripheral circuit includes a first lower transistor vertically overlapping the memory region and a second lower transistor vertically overlapping the peripheral region, wherein the cell contact plug includes a cell lower conductive layer and a cell upper conductive layer sequentially stacked, wherein the peripheral contact plug includes a peripheral lower conductive layer and a peripheral upper conductive layer sequentially stacked, wherein the cell lower conductive layer and the peripheral lower conductive layer include a first conductive material, wherein the cell upper conductive layer and the peripheral upper conductive layer include a second conductive material different from the first conductive material, and wherein the upper interconnection includes a third conductive material different from the first and second conductive materials.

### BRIEF DESCRIPTION OF DRAWINGS

The above and other aspects, features, and advantages of the present disclosure will be more clearly understood from the following detailed description, taken in combination with the accompanying drawings, in which:
FIG. 1 is a perspective diagram illustrating a semiconductor device according to example embodiments of the present disclosure;
FIG. 2 is a circuit diagram illustrating a memory region of a semiconductor device according to example embodiments of the present disclosure;
FIGS. 3, 4, 5A, 5B, and 6 are diagrams illustrating a semiconductor device according to example embodiments of the present disclosure;
FIG. 7 is an enlarged diagram illustrating an example of a semiconductor device according to example embodiments of the present disclosure;
FIG. 8 is an enlarged diagram illustrating an example of a semiconductor device according to example embodiments of the present disclosure;
FIG. 9 is an enlarged diagram illustrating an example of a semiconductor device according to example embodiments of the present disclosure;
FIG. 10 is an enlarged diagram illustrating an example of a semiconductor device according to example embodiments of the present disclosure;
FIGS. 11, 12A, and 12B are diagrams illustrating a semiconductor device according to example embodiments of the present disclosure;
FIG. 13A is a cross-sectional diagram illustrating an example of a semiconductor device according to example embodiments of the present disclosure;
FIG. 13B is a cross-sectional diagram illustrating an example of a semiconductor device according to example embodiments of the present disclosure;
FIG. 13C is a cross-sectional diagram illustrating an example of a semiconductor device according to example embodiments of the present disclosure;
FIG. 13D is a cross-sectional diagram illustrating an example of a semiconductor device according to example embodiments of the present disclosure;
FIG. 13E is a cross-sectional diagram illustrating an example of a semiconductor device according to example embodiments of the present disclosure; and
FIGS. 14 to 23 are cross-sectional diagrams illustrating a method of forming a semiconductor device according to example embodiments of the present disclosure.

### DETAILED DESCRIPTION

Hereinafter, terms such as "upper portion," "middle portion," and "lower portion" may be replaced with other terms, for example, "first," "second," and "third" to describe elements of the specification. Terms such as "first," "second," and "third" may be used to describe different elements, but the elements are not limited by the terms, and a "first element" may be referred to as a "second element." In the specification, terms such as 'lower', 'upper', 'upper end', and 'lower end' may be terms that are described with reference to the drawings.

An item, layer, or portion of an item or layer described as "extending" or as extending "lengthwise" in a particular direction has a length in the particular direction and a width perpendicular to that direction, where the length is greater than the width.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

Throughout the specification, when a component is described as "including" a particular element or group of elements, it is to be understood that the component is formed of only the element or the group of elements, or the element or group of elements may be combined with additional elements to form the component, unless the context indicates otherwise. The term "consisting of," on the other hand, indicates that a component is formed only of the element(s) listed.

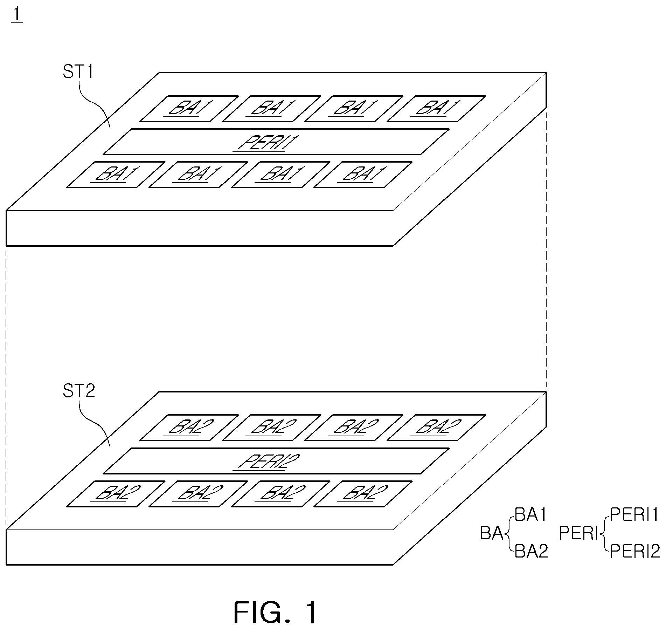

A semiconductor device will be described according to an example embodiment in FIG. 1. FIG. 1 is a perspective diagram illustrating a semiconductor device according to example embodiments.

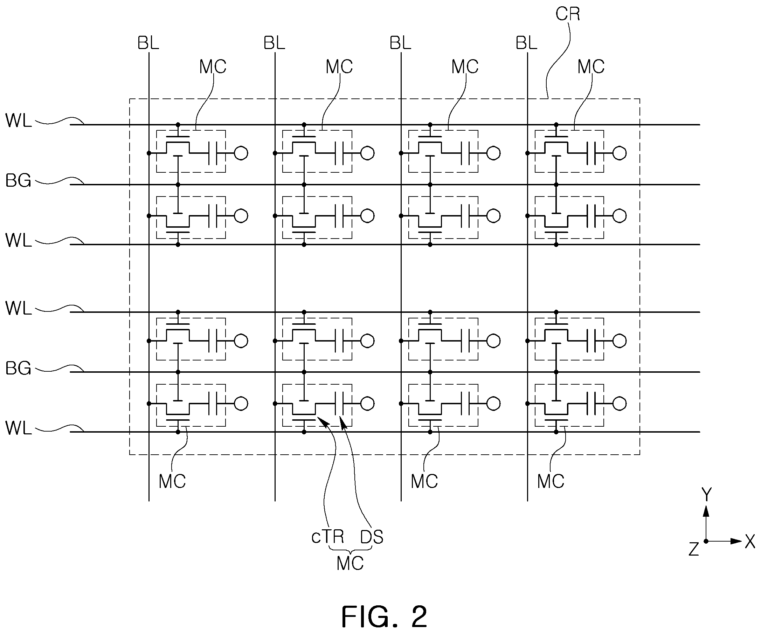

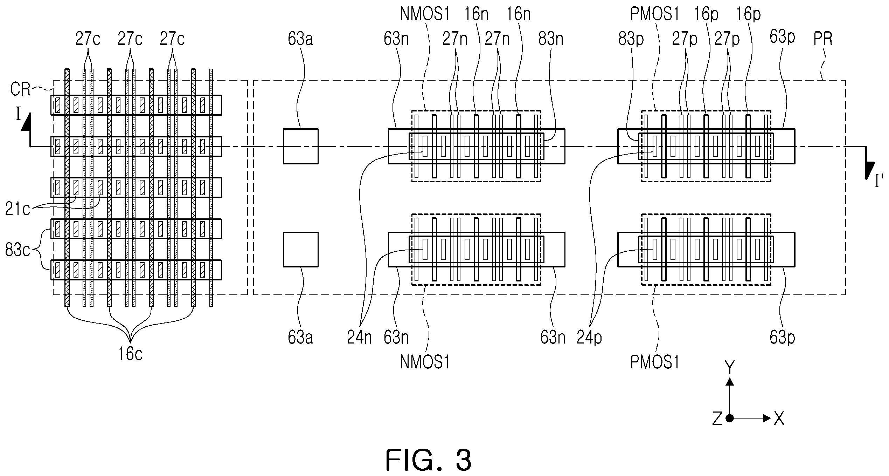

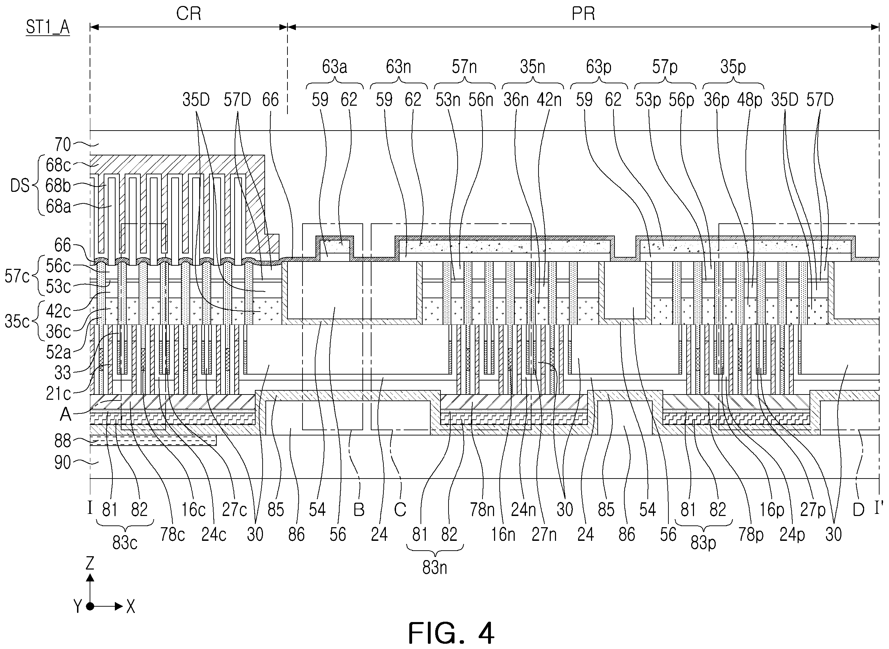

Referring to FIG. 1, a semiconductor device 1 according to an example embodiment may include a first structure ST1 and a second structure ST2 vertically overlapping the first structure ST1. The second structure ST2 may be disposed below the first structure ST1. In example embodiments, the second structure ST2 may be disposed on the first structure ST1. In an example embodiment, the first structure ST1 may be a first chip structure including a memory region (CR in FIGS. 2, 3, and 4) and a peripheral region (PR in FIGS. 3 and 4), and the second structure ST2 may be a second chip structure including a peripheral circuit. The first structure ST1 and the second structure ST2 may be bonded to each other by a bonding process such as a wafer bonding process. Accordingly, the first structure ST1 may be in contact with and bonded to the second structure ST2.

The semiconductor device 1 may include a plurality of banks BA and an external peripheral region PERI. The external peripheral region PERI may include a first peripheral region PERI1 in the first structure ST1 and a second peripheral region PERI2 in the second structure ST2. The external peripheral region PERI may be a peripheral region in which peripheral circuits for input and output of data or commands, or input of power/ground, are disposed. Each of the plurality of banks BA may include a first bank region BA1 in the first structure ST1 and a second bank region BA2 in the second structure ST2. The first bank region BA1 in the first structure ST1 may include memory cells MC (as illustrated in FIG. 2). The second bank region BA2 in the second structure ST2 may include peripheral circuits such as a sense amplifier and a sub-wordline driver.

In the description below, a circuit of the memory region CR of the first structure ST1 will be described with reference to FIG. 2. FIG. 2 is a circuit diagram illustrating a memory region of a semiconductor device according to example embodiments.

Referring to FIG. 2, the memory region CR may include memory cells MC. The memory region CR may include memory cells MC arranged in a grid pattern in the first direction X and the second direction Y, wordlines WL connected to the memory cells MC and extending in the first direction X, and bit lines BL connected to the memory cells MC and extending in the second direction Y. The first direction X and the second direction Y may be perpendicular to each other. The wordlines WL may cross the memory region CR by extending in the first direction X. The bit lines BL may cross the memory region CR by extending in the second direction Y. Each of the memory cells MC may include a data storage structure DS working as data storage and a cell transistor cTR electrically connected to the data storage structure DS. In a memory such as DRAM, the data storage structure DS may be a cell capacitor which may store information. The memory region CR may further include back gate lines BG. Each of the back gate lines BG may be disposed between a pair of wordlines WL adjacent to each other in the second direction Y among the wordlines WL. Each of the back gate lines BG may be disposed between the vertical channel regions of the cell transistors cTR.

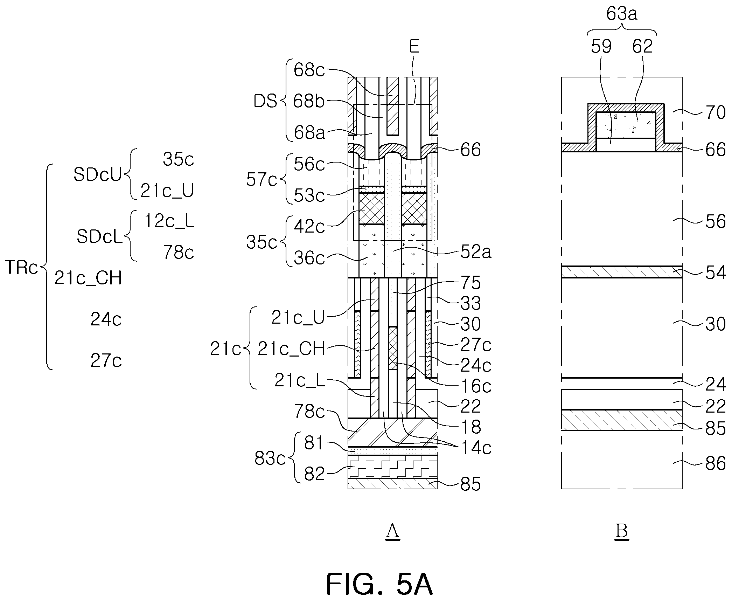

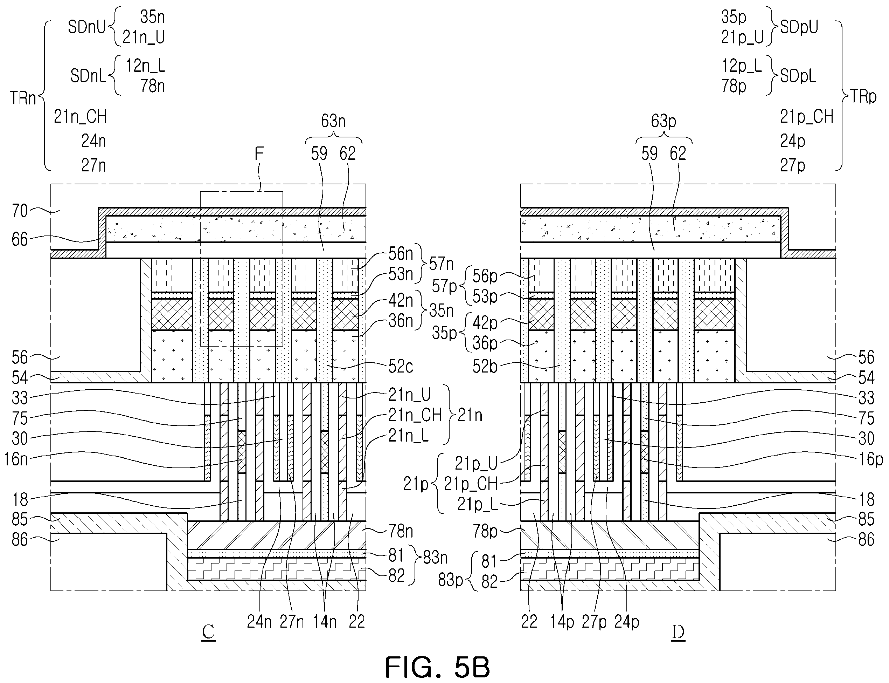

An example of a first portion ST1_A of the first structure ST1 of a semiconductor device according to an example embodiment will be described with reference to FIGS. 3, 4, 5A, 5B and 6, together with FIGS. 1 and 2. In FIGS. 3, 4, 5A, 5B and 6, FIG. 3 is a plan diagram illustrating a semiconductor device according to an example embodiment, FIG. 4 is a cross-sectional diagram illustrating a region taken along line I-I' in FIG. 3, FIG. 5A is an enlarged cross-sectional diagram illustrating regions indicated by 'A' and 'B' in FIG. 4, FIG. 5B is an enlarged cross-sectional diagram illustrating regions indicated by 'C' and 'D' in FIG. 4.

Referring to FIG. 1, FIG. 2, FIG. 3, FIG. 4, FIG. 5A, FIG. 5B and FIG. 6, a first structure ST1 of the semiconductor device 1 may include a memory region CR and a peripheral region PR. Hereinafter, the memory region CR and the peripheral region PR in the first portion ST1_A of the first structure ST1 of the semiconductor device 1 will be described.

The memory region CR may include cell vertical active patterns 21c, cell gate electrodes 27c, cell upper extended source/drain patterns 35c, cell contact plugs 57c, and a cell isolation pattern 52a. The peripheral region PR may include first peripheral vertical active patterns 21n, first peripheral gate electrodes 27n, first peripheral upper extended source/drain patterns 35n, first peripheral upper contact plugs 57n, and a first peripheral isolation pattern 52c. The peripheral region PR may further include second peripheral vertical active patterns 21p, second peripheral gate electrodes 27p, second peripheral upper extended source/drain patterns 35p, second peripheral upper contact plugs 57p, and a second peripheral isolation pattern 52b.

Each of the cell vertical active patterns 21c may include a cell lower source/drain region 21c_L, a cell vertical channel region 21c_CH on the cell lower source/drain region 21c_L, and a cell upper source/drain region 21c_U on the cell vertical channel region 21c_CH. Each of the first peripheral vertical active patterns 21n may include a first peripheral lower source/drain region 21n_L, a first peripheral vertical channel region 21n_CH on the first peripheral lower source/drain region 21n_L, and a first peripheral upper source/drain region 21n_U on the first peripheral vertical channel region 21n_CH. Each of the second peripheral vertical active patterns 21p may include a second peripheral lower source/drain region 21p_L, a second peripheral vertical channel region 21p_CH on the second peripheral lower source/drain region 21p_L, and a second peripheral upper source/drain region 21p_U on the second peripheral vertical channel region 21p_CH.

The cell gate electrodes 27c may be the wordlines WL described with reference to FIG. 2. The cell gate electrodes 27c may have side surfaces facing side surfaces of the cell vertical active patterns 21c. The first peripheral gate electrodes 27n may have side surfaces facing the side surfaces of the first peripheral vertical active patterns 21n. The second peripheral gate electrodes 27p may have side surfaces facing side surfaces of the second peripheral vertical active patterns 21p.

Each of the cell upper extended source/drain patterns 35c may include a cell lower source/drain layer 36c and a cell upper source/drain layer 42c, sequentially stacked. Vertically extending side surfaces of the cell lower source/drain layer 36c and the cell upper source/drain layer 42c may be aligned. Each of the first peripheral upper extended source/drain patterns 35n may include a first peripheral lower source/drain layer 36n and a first peripheral upper source/drain layer 42n, sequentially stacked. Vertically extending side surfaces of the first peripheral lower source/drain layer 36n and the first peripheral upper source/drain layer 42n may be aligned. Each of the second peripheral upper extended source/drain patterns 35p may include the second peripheral lower source/drain layer 36p and the second peripheral upper source/drain layer 48p, which are sequentially stacked. Vertically extending side surfaces of the second peripheral lower source/drain layer 36p and the second peripheral upper source/drain layer 48p may be aligned.

The cell upper extended source/drain patterns 35c may have N-type conductivity. The first peripheral upper extended source/drain patterns 35n may have N-type conductivity. The second peripheral upper extended source/drain patterns 35p may have P-type conductivity.

The cell upper source/drain layer 42c may have a concentration of impurities higher than a concentration of impurities of the cell lower source/drain layer 36c. A concentration of impurities of the cell lower source/drain layer 36c may be higher than a concentration of impurities of the cell upper source/drain region 21c_U. A concentration of impurities of the first peripheral upper source/drain layer 42n may be higher than a concentration of impurities of the first peripheral lower source/drain layer 36n. A concentration of impurities of the first peripheral lower source/drain layer 36n may be higher than a concentration of impurities of the first peripheral upper source/drain region 21n_U. The second peripheral upper source/drain layer 48p may have a concentration of impurities higher than a concentration of impurities of the second peripheral lower source/drain layer 36p. A concentration of impurities in the second peripheral lower source/drain layer 36p may be higher than a concentration of impurities in the second peripheral upper source/drain region 21p_U.

The vertical active patterns 21c, 21n, and 21p may be disposed at substantially the same vertical level. The upper extended source/drain patterns 35c, 35n, and 35p may be disposed at substantially the same vertical level. The upper extended source/drain patterns 35c, 35n, and 35p may vertically overlap the vertical active patterns 21c, 21n, and 21p, respectively, and may be in contact with the vertical active patterns 21c, 21n, and 21p, respectively. A width in the first horizontal direction X of each of the upper extended source/drain patterns 35c, 35n, and 35p may be larger than a width in the first horizontal direction X of each of the vertical active patterns 21c, 21n, and 21p. The memory region CR and the peripheral region PR may further include dummy source/drain patterns 35D disposed at the same vertical level as the upper extended source/drain patterns 35c, 35n, and 35p. The dummy source/drain patterns 35D may be formed of the same material as a material of the upper extended source/drain patterns 35c, 35n, and 35p and may have the same structure as a structure of the upper extended source/drain patterns 35c, 35n, and 35p. The dummy source/drain patterns 35D may be spaced apart from the vertical active patterns 21c, 21n, and 21p.

The cell contact plugs 57c may be disposed on the cell upper extended source/drain patterns 35c. Each of the cell contact plugs 57c may include a cell lower conductive layer 53c in contact with an upper surface of the cell upper source/drain layer 42c and a cell upper conductive layer 56c on the cell lower conductive layer 53c. The cell lower conductive layer 53c and the cell upper conductive layer 56c may be sequentially stacked. The cell lower conductive layer 53c and the cell upper conductive layer 56c, sequentially stacked, may have vertically extending side surfaces coplanar with each other. The cell upper extended source/drain patterns 35c and the cell contact plugs 57c, sequentially stacked, may have vertically extending side surfaces aligned with each other. The cell upper extended source/drain pattern 35c and the cell contact plug 57c, sequentially stacked, may have vertically extending side surfaces coplanar with each other.

The first peripheral upper contact plugs 57n may be disposed on the first peripheral upper extended source/drain patterns 35n. Each of the first peripheral upper contact plugs 57n may include a first peripheral lower conductive layer 53n in contact with an upper surface of the first peripheral upper source/drain layer 42n and a first peripheral upper conductive layer 56n on the first peripheral lower conductive layer 53n. The first peripheral lower conductive layer 53n and the first peripheral upper conductive layer 56n may be sequentially stacked. The first peripheral lower conductive layer 53n and the first peripheral upper conductive layer 56n, sequentially stacked, may have vertically extending side surfaces coplanar with each other. The first peripheral upper extended source/drain patterns 35n and the first peripheral upper contact plugs 57n, sequentially stacked, may have vertically extending side surfaces aligned with each other. The first peripheral upper extended source/drain pattern 35n and the first peripheral upper contact plug 57n, sequentially stacked, may have vertically extending side surfaces coplanar with each other.

The second peripheral upper contact plugs 57p may be disposed on the second peripheral upper extended source/drain patterns 35p. Each of the second peripheral upper contact plugs 57p may include a second peripheral lower conductive layer 53p in contact with an upper surface of the second peripheral upper source/drain layer 48p and a second peripheral upper conductive layer 56p on the second peripheral lower conductive layer 53p. The second peripheral lower conductive layer 53p and the second peripheral upper conductive layer 56p, sequentially stacked, may have vertically extending side surfaces coplanar with each other. The second peripheral upper extended source/drain patterns 35p and the second peripheral upper contact plugs 57p, sequentially stacked, may have vertically extending side surfaces aligned with each other. The second peripheral upper extended source/drain pattern 35p and the second peripheral upper contact plug 57p, sequentially stacked, may have vertically extending side surfaces coplanar with each other.

The contact plugs 57c, 57n, and 57p may be aligned with and in contact with the upper extended source/drain patterns 35c, 35n, and 35p. The memory region CR and the peripheral region PR may further include dummy contact plugs 57D aligned with and in contact with the dummy source/drain patterns 35D. The dummy contact plugs 57D may be disposed at the same level as the contact plugs 57c, 57n, and 57p and may be formed of the same material as that of the contact plugs 57c, 57n, and 57p and may have the same structure as that of the contact plugs 57c, 57n, and 57p.

The cell isolation pattern 52a may define vertically extending side surfaces of the cell upper extended source/drain patterns 35c and the cell contact plugs 57c sequentially stacked. The first peripheral isolation pattern 52c may define vertically extending side surfaces of the first peripheral upper extended source/drain patterns 35n and the first peripheral upper contact plugs 57n, sequentially stacked. The second peripheral isolation pattern 52b may define vertically extending side surfaces of the second peripheral upper extended source/drain patterns 35p and the second peripheral upper contact plugs 57p, sequentially stacked. The cell isolation pattern 52a may surround side surfaces of the cell upper extended source/drain patterns 35c and the cell contact plugs 57c, sequentially stacked, the first peripheral isolation pattern 52c may surround side surfaces of the first peripheral upper extended source/drain patterns 35n and the first peripheral upper contact plugs 57n, sequentially stacked, and the second peripheral isolation pattern 52b may surround side surfaces of the second peripheral upper extended source/drain patterns 35p and the second peripheral upper contact plugs 57p, sequentially stacked. The cell isolation pattern 52a, the first peripheral isolation pattern 52c and the second peripheral isolation pattern 52b may be disposed at the same vertical level and may include the same insulating material. For example, the cell isolation pattern 52a, the first peripheral isolation pattern 52c and the second peripheral isolation pattern 52b may include an insulating material of silicon nitride or silicon oxide.

In an example, a difference (e.g., a distance) between a level of an upper end of the cell contact plug 57c and a level of an upper end of the cell isolation pattern 52a may be different from a difference (e.g., a distance) between a level of an upper end of the first peripheral contact plug 57n and a level of an upper end of the first peripheral isolation pattern 52c.

In an example, a difference between a level of an uppermost point of an upper end of the cell contact plug 57c and a level of an uppermost point of an upper end of the cell isolation pattern 52a may be greater than a difference between a level of an uppermost point of an upper end of the first peripheral contact plug 57n and a level of an uppermost point of an upper end of the first peripheral isolation pattern 52c.

In an example, an uppermost point of an upper surface of the cell contact plug 57c may be disposed at a level lower than a level of an uppermost point of an upper surface of the cell isolation pattern 52a.

In an example, the cell lower conductive layer 53c, the first peripheral lower conductive layer 53n, and the second peripheral lower conductive layer 53p may be disposed at the same vertical level and may have the same thickness.

In an example, a thickness of the cell upper conductive layer 56c may be different from thicknesses of each of the first peripheral upper conductive layer 56n and the second peripheral upper conductive layer 56p.

In an example, a thickness of the cell upper conductive layer 56c may be smaller than a thickness of each of the first peripheral upper conductive layer 56n and the second peripheral upper conductive layer 56p. For example, the thickness of the cell upper conductive layer 56c may vary along the first horizontal direction. For example, a smallest thickness of the cell upper conductive layer 56c may be smaller than the thickness of each of the first peripheral upper conductive layer 56n and the second peripheral upper conductive layer 56p.

In an example, the first peripheral upper conductive layer 56n and the second peripheral upper conductive layer 56p may have upper surfaces disposed at the same vertical level.

In an example, a lowermost point of an upper surface of the cell upper conductive layer 56c may be disposed at a vertical level different from a vertical level of an upper surface of the first peripheral upper conductive layer 56n.

In an example, the lowermost point of the upper surface of the cell upper conductive layer 56c may be disposed at a level lower than a level of the upper surface of the first peripheral upper conductive layer 56n.

In an example, the upper surface of the cell upper conductive layer 56c may have a concave shape, and the first and second peripheral upper conductive layers 56n and 56p may have substantially flat upper surfaces. For example, the ends of the upper surface of the cell upper conductive layer 56c in the first horizontal direction X may be at a higher vertical level than the center of the upper surface of the cell upper conductive layer 56c in the first horizontal direction X.

In an example, the uppermost point of the upper end of the cell isolation pattern 52a, the uppermost point of the upper end of the first peripheral isolation pattern 52c, and the uppermost point of the upper end of the second peripheral isolation pattern 52b may be disposed at the same vertical level.

In an example, the upper surface of the cell isolation pattern 52a may have a convex shape. For example, the ends of the upper surface of the cell isolation pattern 52a in the first horizontal direction X may be at a lower vertical level than the center of the upper surface of the cell isolation pattern 52a in the first horizontal direction X.

In embodiments, the upper surface of the cell upper conductive layer 56c may be the upper surface of the cell contact plug 57c, the upper surface of the first peripheral upper conductive layer 56n may be the upper surface of the first peripheral contact plug 57n, and the upper surface of the second peripheral upper conductive layer 56p may be the upper surface of the second peripheral contact plug 57p.

The peripheral region PR may further include conductive patterns 63a, 63n, and 63p, disposed at the same vertical level as each other and including the same material.

The conductive patterns 63a, 63n, and 63p may include a pad pattern 63a, a first upper interconnection 63n, and a second upper interconnection 63p.

The first upper interconnection 63n may be connected to the first peripheral upper contact plugs 57n. The second upper interconnection 63p may be connected to the second peripheral upper contact plugs 57p. The pad pattern 63a may not vertically overlap any of the first and second peripheral upper plugs 57n and 57p.

In an example, the cell lower conductive layer 53c, the first peripheral lower conductive layer 53n, and the second peripheral lower conductive layer 53p may include a first conductive material. The cell upper conductive layer 56c, the first peripheral upper conductive layer 56n, and the second peripheral upper conductive layer 56p may include a second conductive material different from the first conductive material.

In an example, the first conductive material may include a metal-semiconductor compound layer, and the second conductive material may include metal nitride or a metal. For example, each of the cell lower conductive layer 53c, the first peripheral lower conductive layer 53n, and the second peripheral lower conductive layer 53p may include TiSi, TiSiN, TaSi, TaSiN, MoSi, NiSi, or CoSi. Each of the cell upper conductive layer 56c, the first peripheral upper conductive layer 56n, and the second peripheral upper conductive layer 56p may include at least one of Al, Cu, Ti, Ta, Ru, W, Mo, Pt, Ni, Co, TiN, TaN, WN, NbN, TiAl, TiAlN and RuTiN.

In an example, each of the conductive patterns 63a, 63n, and 63p may include a third conductive material different from the first and second conductive materials. For example, each of the conductive patterns 63a, 63n, and 63p may include at least one of Al, Cu, Ti, Ta, Ru, W, Mo, Pt, Ni, Co, TiN, TaN, WN, NbN, TiAl, TiAlN and RuTiN. The second and third conductive materials may include different materials from among Al, Cu, Ti, Ta, Ru, W, Mo, Pt, Ni, Co, TiN, TaN, WN, NbN, TiAl, TiAlN and RuTiN.

In an example, each of the conductive patterns 63a, 63n and 63p may include the second conductive material. For example, the conductive patterns 63a, 63n and 63p may include the same material as the cell upper conductive layer 56c, the first peripheral upper conductive layer 56n, and the second peripheral upper conductive layer 56p.

In an example, each of the conductive patterns 63a, 63n, and 63p may include the second conductive material that is the same as the cell upper conductive layer 56c, the first peripheral upper conductive layer 56n, and the second peripheral upper conductive layer 56p and a third conductive material different from the second conductive material.

In an example, each of the conductive patterns 63a, 63n, and 63p may include a first upper conductive layer 59 and a second upper conductive layer 62 sequentially stacked. The first upper conductive layer 59 may include a material different from the material of the first peripheral upper conductive layer 56n and the second peripheral upper conductive layer 56p.

In an example, the second upper conductive layer 62 may include a material different from the material of the first upper conductive layer 59 and the same as the material of the first peripheral upper conductive layer 56n and the second peripheral upper conductive layer 56p.

In an example, the second upper conductive layer 62 may include a material different from the material of the first upper conductive layer 59 and different from the material of the first peripheral upper conductive layer 56n and the second peripheral upper conductive layer 56p.

The memory region CR and the peripheral region PR may further include an insulating liner 66. The insulating liner 66 may be disposed on the cell contact plugs 57c, the cell isolation pattern 52a, and the upper conductive patterns 63a, 63n, and 63p. The insulating liner 66 may cover upper surfaces of the cell contact plugs 57c and the cell isolation pattern 52a in the memory region CR, and may cover upper surfaces and side surfaces of the upper conductive patterns 63a, 63n, and 63p in the peripheral region PR. The insulating liner 66 may include an insulating material, such as SiN, SiBN, SiCN, or a high-κ dielectric.

The memory region CR and the peripheral region PR may further include a data storage structure DS and an insulating layer 70.

The data storage structure DS may include first electrodes 68a connected to the cell contact plugs 57c in the memory region CR, penetrating the insulating liner 66, and extending in the vertical direction Z, a second electrode 68c on each of side surfaces and upper surfaces of the first electrodes 68a, and a dielectric layer 68b between the first electrodes 68a and the second electrode 68c. The data storage structure DS may be a cell capacitor of a memory such as a DRAM.

The insulating layer 70 may cover the data storage structure DS in the memory region CR and the insulating liner 66 in the peripheral region PR. The insulating layer 70 may include at least one of silicon oxide or a low-κ dielectric.

The memory region CR and the peripheral region PR may further include lower source/drain patterns 78c, 78n, and 78p connected to the vertical active patterns 21c, 21n, and 21p below the vertical active patterns 21c, 21n, and 21p and lower interconnection patterns 83c, 83n, and 83p aligned with the lower source/drain patterns 78c, 78n, and 78p below the lower source/drain patterns 78c, 78n, and 78p.

The lower source/drain patterns 78c, 78n, and 78p may include a cell lower source/drain pattern 78c connected to the cell vertical active patterns 21c, a first peripheral lower source/drain pattern 78n connected to the first peripheral vertical active patterns 21n, and a second peripheral lower source/drain pattern 78p connected to the first peripheral vertical active patterns 21p.

The lower interconnection patterns 83c, 83n, and 83p may include a bit line 83c aligned with and in contact with the cell lower source/drain pattern 78c, a first lower interconnection 83n aligned with and in contact with the first peripheral lower source/drain pattern 78n, and a second lower interconnection 83p aligned with and in contact with the second peripheral lower source/drain pattern 78p. Each of the lower interconnection patterns 83c, 83n, and 83p may include a first lower conductive layer 81 and a second lower conductive layer 82 disposed below the first lower conductive layer 81. The bit line 83c may be the bit line BL described with reference to FIG. 2. The memory region CR may further include cell gate dielectric layers 24c, cell back gate electrodes 16c, cell back gate dielectric layers 14c, and insulating layers 18, 33, 30, and 75. The peripheral region PR may further include first peripheral gate dielectric layers 24n, first peripheral back gate electrodes 16n, first peripheral back gate dielectric layers 14n, second peripheral gate dielectric layers 24p, second peripheral back gate electrodes 16p, second peripheral back gate dielectric layers 14p, insulating layers 18, 33, 30, and 75, and insulating structures 54, 56.

The cell back gate electrodes 16c may be the back gate lines BG described with reference to FIG. 2. Each of the cell gate electrodes 27c may extend in the second horizontal direction Y. The cell gate electrodes 27c may be spaced apart from each other in the first horizontal direction X perpendicular to the second horizontal direction Y. Each of the cell back gate electrodes 16c may have a line shape extending in the second horizontal direction Y.

For each pair of adjacent cell back gate electrodes 16c, a pair of cell gate electrodes 27c may be disposed therebetween (see, e.g., FIG. 4). On a plane, each of the cell vertical active patterns 21c may have a bar shape extending in the second horizontal direction Y. Each of the cell vertical active patterns 21c may be disposed between a cell back gate electrode 16c and a cell gate electrode 27c that is adjacent to the cell back gate electrode 16c.

Each of the first peripheral gate electrodes 27n may extend in the second horizontal direction Y. Each of the first peripheral back gate electrodes 16n may have a line shape extending in the second horizontal direction Y. Among the first peripheral gate electrodes 27n, a pair of the first peripheral gate electrodes 27n adjacent to each other in the first horizontal direction X may be disposed between a pair of the first peripheral back gate electrodes 16n adjacent to each other in the first horizontal direction X. On a plane, each of the first peripheral vertical active patterns 21n may have a bar shape extending in the second horizontal direction Y. Each of the first peripheral vertical active patterns 21n may be disposed between a first peripheral back gate electrode 16n and a first peripheral gate electrode 27n that is adjacent to the first peripheral back gate electrode 16n among the first peripheral back gate electrodes 16n and the first peripheral gate electrodes 27n.

Each of the second peripheral gate electrodes 27p may extend in the second horizontal direction Y. Each of the second peripheral back gate electrodes 16p may have a line shape extending in the second horizontal direction Y. Among the second peripheral gate electrodes 27p, a pair of second peripheral gate electrodes 27p, adjacent to each other in the first horizontal direction X, may be disposed between a pair of the second peripheral back gate electrodes 16p adjacent to each other in the first horizontal direction X. On a plane, each of the second peripheral vertical active patterns 21p may have a bar shape extending in the second horizontal direction Y. Each of the second peripheral vertical active patterns 21p may be disposed between a second peripheral back gate electrode 16p and a second peripheral gate electrode 27p that is adjacent to the second peripheral back gate electrode 16p among the second peripheral back gate electrodes 16p and the second peripheral gate electrodes 27p.

The cell gate dielectric layers 24c may be disposed between side surfaces of the cell vertical active patterns 21c and the cell gate electrodes 27c. The cell gate dielectric layers 24c may extend to cover lower surfaces of the cell gate electrodes 27c. The cell gate 24c, 27c including the cell gate dielectric layer 24c and the cell gate electrode 27c may face a side surface of the cell vertical channel region 21c_CH. The first peripheral gate dielectric layers 24n may be disposed between side surfaces of the first peripheral vertical active patterns 21n and the first peripheral gate electrodes 27n. The first peripheral gate 24n, 27n including the first peripheral gate dielectric layer 24n and the first peripheral gate electrode 27n may face a side surface of the first peripheral vertical channel region 21n_CH. The first peripheral gate dielectric layers 24n may extend to cover lower surfaces of the first peripheral gate electrodes 27n. The second peripheral gate dielectric layers 24p may be disposed between side surfaces of the second peripheral vertical active patterns 21p and the second peripheral gate electrodes 27p. The second peripheral gate dielectric layers 24p may extend to cover lower surfaces of the second peripheral gate electrodes 27p. The second peripheral gate 24p, 27p including the second peripheral gate dielectric layer 24p and the second peripheral gate electrode 27p, may face a side surface of the second peripheral vertical channel region 21p_CH.

The cell back gate dielectric layers 14c may be disposed between the cell vertical active patterns 21c and the cell back gate electrodes 16c. The first peripheral back gate dielectric layers 14n may be disposed between the first peripheral vertical active patterns 21n and the first peripheral back gate electrodes 16n. The second peripheral back gate dielectric layers 14p may be disposed between the second peripheral vertical active patterns 21p and the second peripheral back gate electrodes 16p.

The insulating layers 18 may be disposed below lower surfaces of the back gate electrodes 16c, 16n, and 16p. The insulating layers 75 may be disposed on upper surfaces of the back gate electrodes 16c, 16n, and 16p. The insulating layers 33 may be disposed on upper surfaces of the gate electrodes 27c, 27n, and 27p. Each of the insulating layers 30 may be disposed between adjacent gate electrodes among the gate electrodes 27c, 27n, and 27p, and between adjacent insulating layers among the insulating layers 33. The insulating layers 22 may be disposed between lower surfaces of the gate dielectric layers 24c, 24n, 24p and the lower source/drain patterns 78c, 78n, and 78p.

Each of the insulating structures 54 and 56 may be disposed between adjacent groups among a group of the cell isolation patterns 52a, a group of the first peripheral isolation patterns 52c, and a group of the second peripheral isolation patterns 52b. Each of the insulating structures 54 and 56 may include an insulating liner 54 covering a side surface and a lower surface of the insulating pattern 56 and the insulating pattern 56. The insulating pattern 56 may include an oxide, and the insulating liner 54 may include a nitride. The pad pattern 63a may be disposed on upper surfaces of the insulating structure 54 and 56.

The memory region CR may further include a bit line shield structure 88, and the memory region CR and the peripheral region PR may further include insulating structures 85 and 86 and an insulating layer 90.

The insulating structure 85 and 86 may include an insulating pattern 86 and an insulating liner 85. The insulating liner 85 may cover side surfaces and an upper surface of the insulating pattern 86, side surfaces of the lower source/drain patterns 78c, 78n, and 78p, and side surfaces and lower surfaces of the lower interconnection patterns 83c, 83n, and 83p.

The bit line shield structure 88 may include vertical portions disposed between the bit lines 83c and a plate portion extending from the vertical portions and vertically overlapping the bit lines 83c. The bit line shield structure 88 may be spaced apart from the bit lines 83c by the insulating liner 85. The insulating layer 90 may be disposed below the insulating structure 85 and 86 and the bit line shield structure 88.

The vertical active patterns 21c, 21n, and 21p may include single crystal silicon. The cell upper extended source/drain patterns 35c and the first peripheral upper extended source/drain patterns 35n may include first polysilicon, for example, polysilicon having N-type conductivity. The second peripheral upper extended source/drain patterns 35p may include second polysilicon, for example, polysilicon having P-type conductivity.

The cell lower source/drain pattern 78c and the first peripheral lower source/drain pattern 78n may include third polysilicon, for example, polysilicon of N-type. The second peripheral lower source/drain pattern 78p may include fourth polysilicon, for example, P-type polysilicon.

A width in the first horizontal direction X of each of the upper extended source/drain patterns 35c, 35n, and 35p may be greater than a width in the first horizontal direction X of each of the vertical active patterns 21c, 21n, and 21p.

The cell upper source/drain SDcU may include the cell upper extended source/drain pattern 35c and the cell upper source/drain region 21c_U. The cell lower source/drain SDcL may include the cell lower source/drain pattern 78c and the cell lower source/drain region 21c_L. The cell upper source/drain SDcU and the cell lower source/drain SDcL may have N-type conductivity.

The cell transistor cTR may include the cell upper source/drain SDcU, the cell lower source/drain SDcL, the cell vertical channel region 21c_CH, the cell gate dielectric layer 24c and the cell gate electrode 27c.

The first peripheral upper source/drain SDnU may include the first peripheral upper extended source/drain pattern 35n and the first peripheral upper source/drain region 21n_U. The first peripheral lower source/drain SDnL may include the first peripheral lower source/drain pattern 78n and the first peripheral lower source/drain region 21n_L. The first peripheral upper source/drain SDnU and the first peripheral lower source/drain SDnL may have N-type conductivity. The first peripheral transistor TRn may include the first peripheral upper source/drain SDnU, the first peripheral lower source/drain SDnL, the first peripheral vertical channel region 21n_CH, the first peripheral gate dielectric layer 24n, and the first peripheral gate electrode 27n. The first peripheral transistor TRn may be an NMOS transistor. A plurality of first peripheral transistors TRn may be disposed, and may be disposed in NMOS transistor regions NMOS1 as shown, e.g., in FIG. 3.

The second peripheral upper source/drain SDpU may include the second peripheral upper extended source/drain pattern 35p and the second peripheral upper source/drain region 21p_U. The second peripheral lower source/drain SDpL may include the second peripheral lower source/drain pattern 78p and the second peripheral lower source/drain region 21p_L. The second peripheral upper source/drain SDpU and the second peripheral lower source/drain SDpL may have P-type conductivity. The second peripheral transistor TRp may include the second peripheral upper source/drain SDpU, the second peripheral lower source/drain SDpL, the second peripheral vertical channel region 21p_CH, the second peripheral gate dielectric layer 24p and the second peripheral gate electrode 27p. The second peripheral transistor TRp may be an NMOS transistor. A plurality of second peripheral transistors TRp may be disposed, and may be disposed in PMOS transistor regions PMOS1 as shown, e.g., in FIG. 3.

Hereinafter, various example embodiments of the semiconductor device 1 will be described. The various example embodiments described below and the example embodiments described above may be combined with each other to form an example embodiment. Hereinafter, components described above may be directly cited without a detailed description, or descriptions may not be provided. Also, components described below which may be modified or replaced may be described with reference to the drawings below, but components which may be modified, replaced, or added may be combined with each other or with the components described above to form a semiconductor device according to an example embodiment.

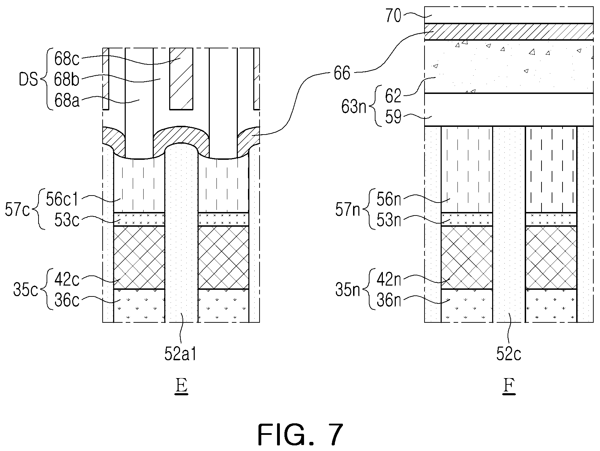

An example of a semiconductor device according to an example embodiment will be described with reference to FIG. 7. FIG. 7 is an enlarged diagram illustrating region 'E' of FIG. 5A and region 'F' of FIG. 5B to describe an example of a semiconductor device according to an example embodiment.

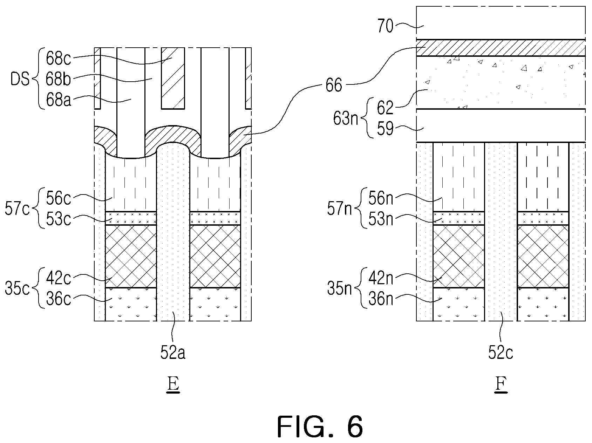

In an example embodiment, referring to FIG. 7, the cell upper conductive layer (56c in FIG. 6) described above may be replaced with a cell upper conductive layer 56c1 having an upper surface having a lower level, and the cell isolation pattern (52a in FIG. 6) described above may be replaced with a cell isolation pattern 52a1 having an upper surface having a lower level. Accordingly, an upper surface of the cell upper conductive layer 56c1 and an upper surface of the cell isolation pattern 52a1 may be disposed at a level lower than a level of an upper surface of the first peripheral upper conductive layer 56n and an upper surface of the first peripheral isolation pattern 52c. Accordingly, the upper surface of the cell contact plug 57c and the upper surface of the cell isolation pattern 52a1 may be disposed at a level lower than a level of the upper surface of the first peripheral contact plug 57n and the upper surface of the first peripheral isolation pattern 52c.

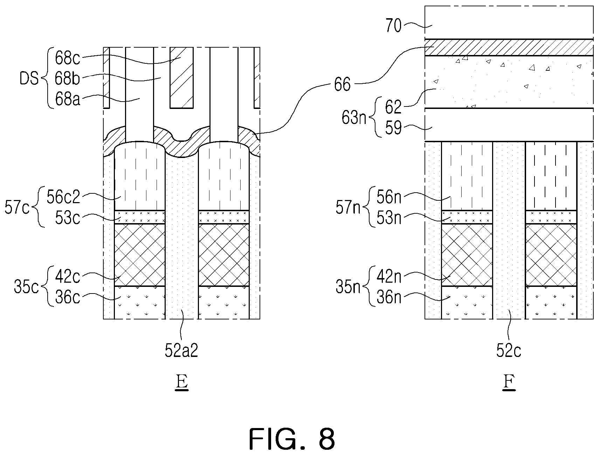

In the description below, an example of a semiconductor device according to an example embodiment will be described with reference to FIG. 8. FIG. 8 is an enlarged diagram illustrating region 'E' of FIG. 5A and region 'F' of FIG. 5B to describe an example of a semiconductor device according to an example embodiment.

In an example embodiment, referring to FIG. 8, the cell upper conductive layer (56c in FIG. 6) described above may be replaced with a cell upper conductive layer 56c2 having an upper surface having a higher level, and the cell isolation pattern (52a in FIG. 6) described above may be replaced with a cell isolation pattern 52a2 having an upper surface having a lower level.

The upper surface of the cell upper conductive layer 56c2 may be disposed at a level higher than a level of the upper surface of the cell isolation pattern 52a1. Accordingly, the upper surface of the cell contact plug 57c may be disposed at a level higher than a level of the upper surface of the cell isolation pattern 52a1. The cell upper conductive layer 56c2 may have a convex upper surface, and the cell isolation pattern 52a1 may have a concave upper surface. The upper surface of the cell isolation pattern 52a1 may be disposed at a level lower than a level of the upper surface of the first peripheral isolation pattern 52c and the upper surface of the first peripheral contact plug 57n. For example, a middle portion of the uppermost surface of the cell upper conductive layer 56c2 may be at a higher vertical level than edge portions of the uppermost surface of the cell upper conductive layer 56c2. For example, a middle portion of the uppermost surface of the cell isolation pattern 52a2 may be at a lower vertical level than edge portions of the uppermost surface of the cell isolation pattern 52a2.

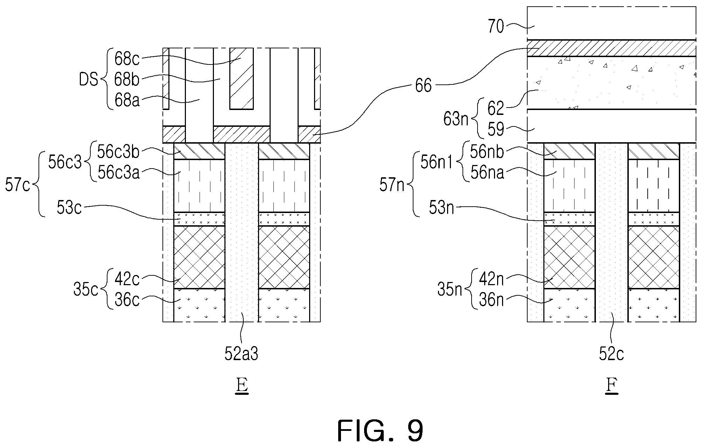

In the description below, an example of a semiconductor device according to an example embodiment will be described with reference to FIG. 9. FIG. 9 is an enlarged diagram illustrating region 'E' of FIG. 5A and region 'F' of FIG. 5B to describe an example of a semiconductor device according to an example embodiment.

In an example embodiment, referring to FIG. 9, the cell upper conductive layer (56c in FIG. 6) described above may be replaced with a cell upper conductive layer 56c3 including a first cell conductive layer 56c3a and a second cell conductive layer 56c3b sequentially stacked, and the first peripheral upper conductive layer (56n in FIG. 6) described above may be replaced with a first peripheral upper conductive layer 56n1 including a first peripheral conductive layer 56na and a second peripheral conductive layer 56nb sequentially stacked.

The first cell conductive layer 56c3a and the first peripheral conductive layer 56na may have the same thickness and may be formed of the same material. The second cell conductive layer 56c3b and the second peripheral conductive layer 56nb may have substantially the same thickness and may be formed of the same material.

The material of the second cell conductive layer 56c3b and the second peripheral conductive layer 56nb may be different from the material of the first cell conductive layer 56c3a and the first peripheral conductive layer 56na.

The material of the second cell conductive layer 56c3b and the second peripheral conductive layer 56nb may be different from the material of the first upper interconnection adjacent to the second peripheral conductive layer 56nb.

The upper surface of the cell contact plug 57c may be disposed at substantially the same level as the upper surface of the first peripheral contact plug 57n. The upper surface of the cell contact plug 57c may be disposed at substantially the same level as the upper surface of the cell isolation pattern 52a3. The upper surface of the cell isolation pattern 52a3 may be disposed at substantially the same level as the upper surface of the first peripheral isolation pattern 52c.

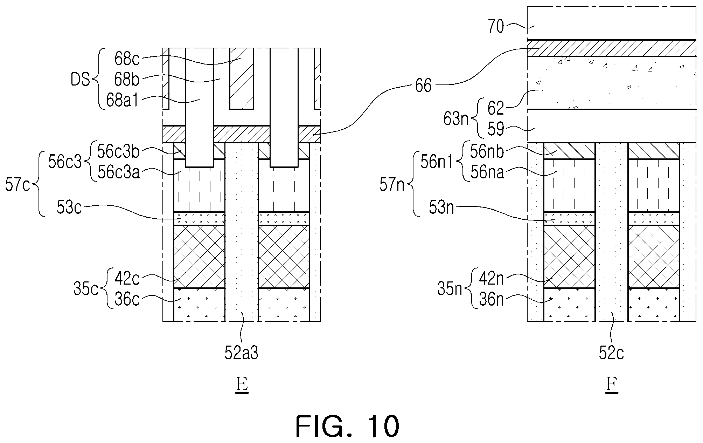

In the description below, an example of a semiconductor device according to an example embodiment will be described with reference to FIG. 10. FIG. 10 is an enlarged diagram illustrating a portion illustrating region 'E' of FIG. 5A and region 'F' of FIG. 5B to describe an example of a semiconductor device according to an example embodiment.

In an example embodiment, referring to FIG. 10, the first electrode (68a in FIG. 6) described above may be replaced with a first electrode 68a1 penetrating the insulating liner 66 and extending into the cell contact plug 57c. The lower surface of the first electrode 68a1 may be disposed at a level lower than the upper surface of the cell contact plug 57c. For example, the first electrode 68a1 may penetrate the second cell conductive layer 56c3b described with reference to FIG. 9 and may be in contact with the first cell conductive layer 56c3a.

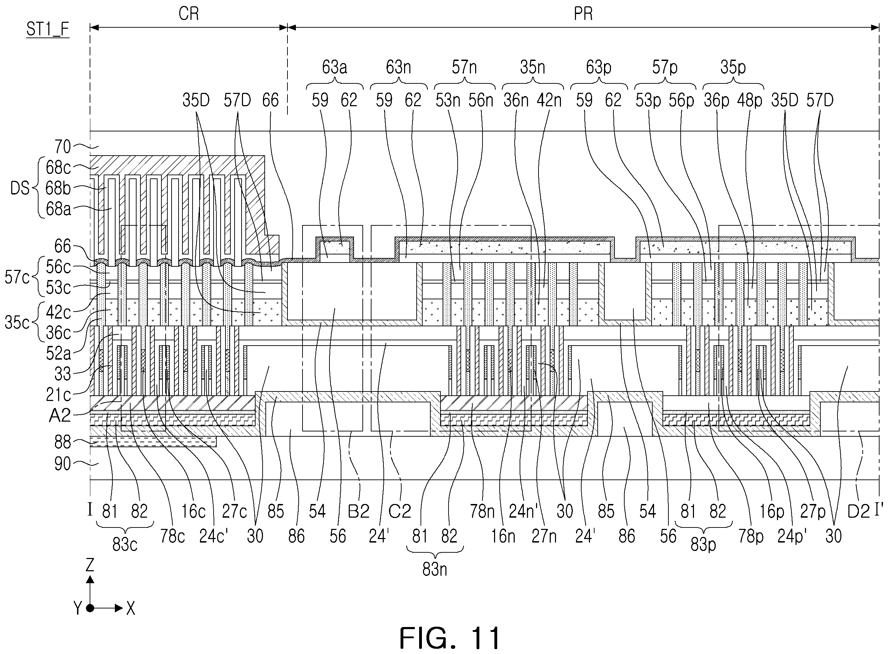

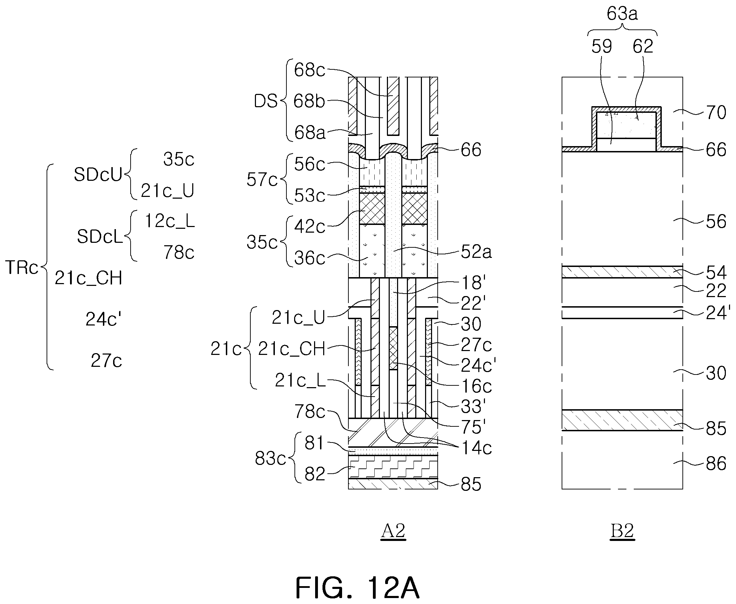

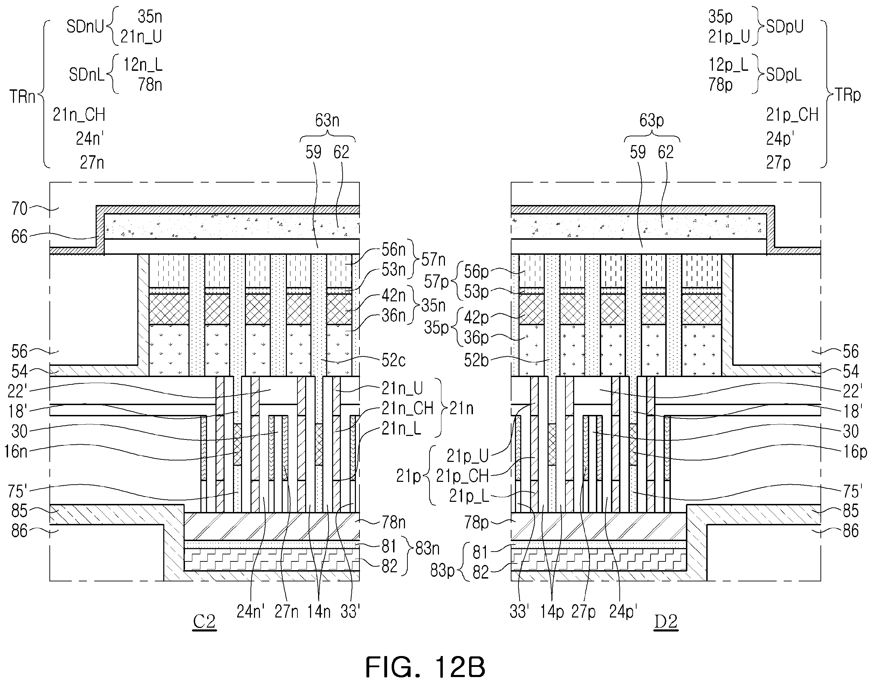

An example of a semiconductor device according to an example embodiment will be described with reference to FIGS. 11, 12A and 12B. FIG. 11 may be a cross-sectional diagram corresponding to FIG. 4 to describe an example of a semiconductor device according to an example embodiment, FIG. 12A may be an enlarged diagram illustrating regions 'A2' and 'B2' illustrated in FIG. 11, and FIG. 12B is an enlarged diagram illustrating regions 'C2' and 'D2' illustrated in FIG. 11.

In an example embodiment, referring to FIGS. 11, 12A and 12B, the first portion (ST1_A in FIG. 4) of the first structure (ST1 in FIG. 1) described above may be replaced with the first portion ST1_F of the first structure (ST1 in FIG. 1) in FIG. 11. The cell gate dielectric layers 24c, the first peripheral gate dielectric layers 24n, the second peripheral gate dielectric layers 24p, and the insulating layers 18, 33, and 75 described with reference to FIGS. 4, 5A and 5B may be replaced with cell gate dielectric layers 24c', first peripheral gate dielectric layers 24n', second peripheral gate dielectric layers 24p', and insulating layers 18', 33', and 75' as in FIGS. 11, 12A and 12B. The cell gate dielectric layers 24c' may be disposed between side surfaces of the cell vertical active patterns 21c and the cell gate electrodes 27c, and may extend to cover upper surfaces of the cell gate electrodes 27c. The first peripheral gate dielectric layers 24n' may be disposed between side surfaces of the first peripheral vertical active patterns 21n and the first peripheral gate electrodes 27n, and may extend to cover upper surfaces of the first peripheral gate electrodes 27n. The second peripheral gate dielectric layers 24p' may be disposed between side surfaces of the second peripheral vertical active patterns 21p and the second peripheral gate electrodes 27p, and may extend to cover upper surfaces of the second peripheral gate electrodes 27p. The insulating layers 18' may be disposed on upper surfaces of the back gate electrodes 16c, 16n, and 16p. The insulating layers 75' may be disposed below lower surfaces of the back gate electrodes 16c, 16n, and 16p. The insulating layers 33' may be disposed below lower surfaces of the gate electrodes 27c, 27n, and 27p. The insulating layers 22' may be disposed on upper surfaces of the gate dielectric layers 24c', 24n', and 24p'.

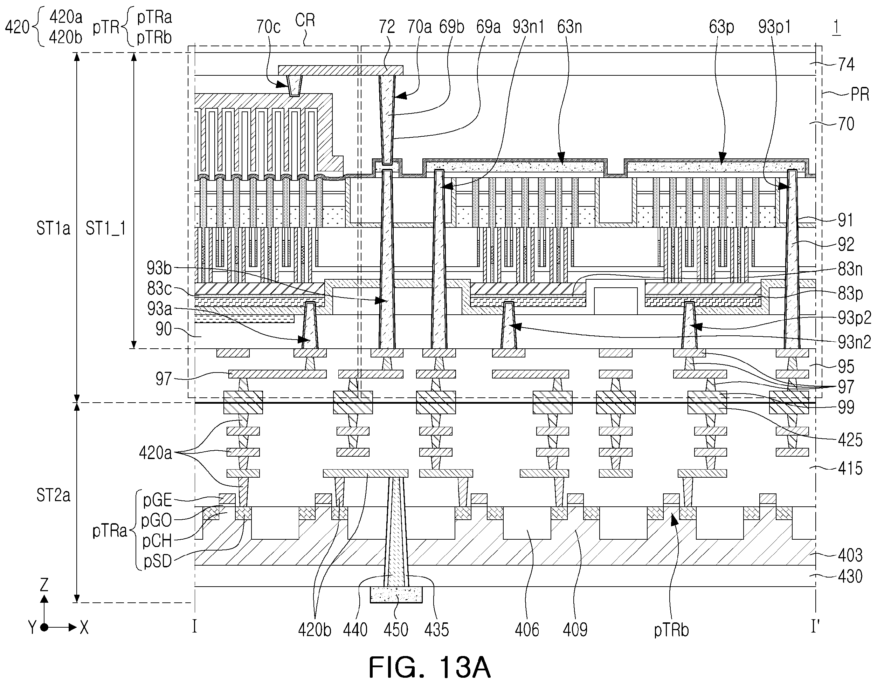

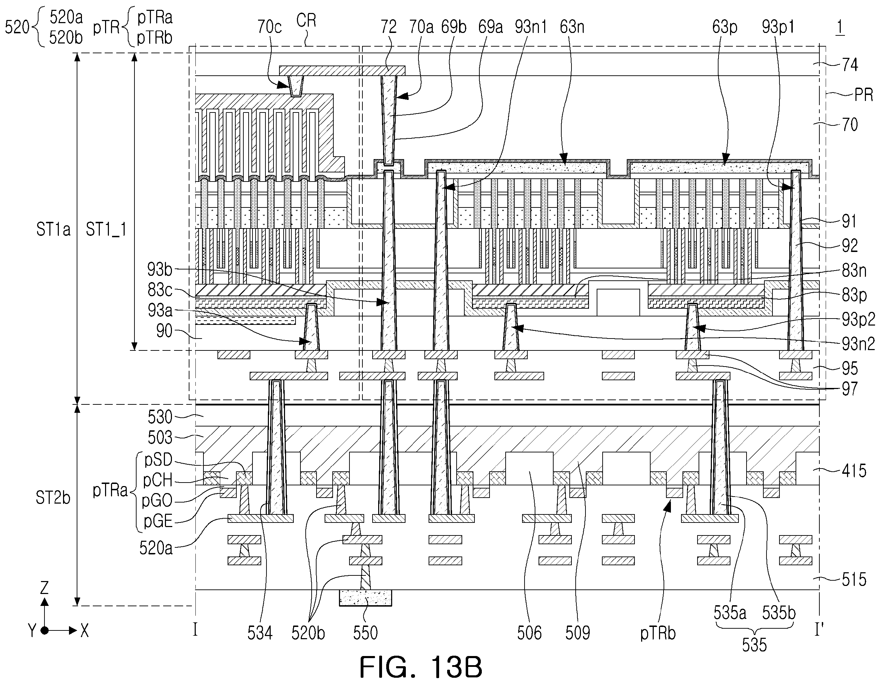

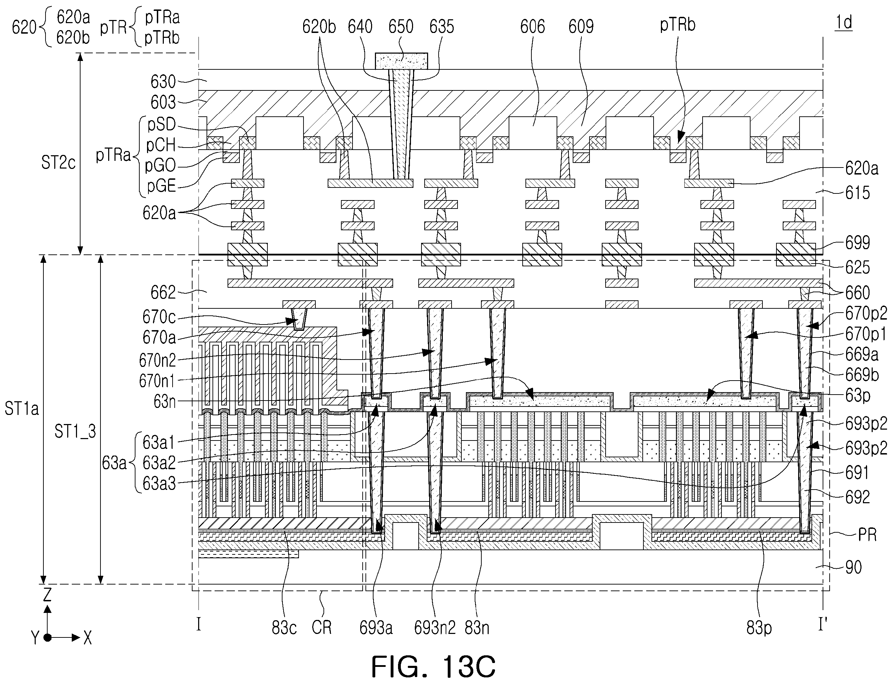

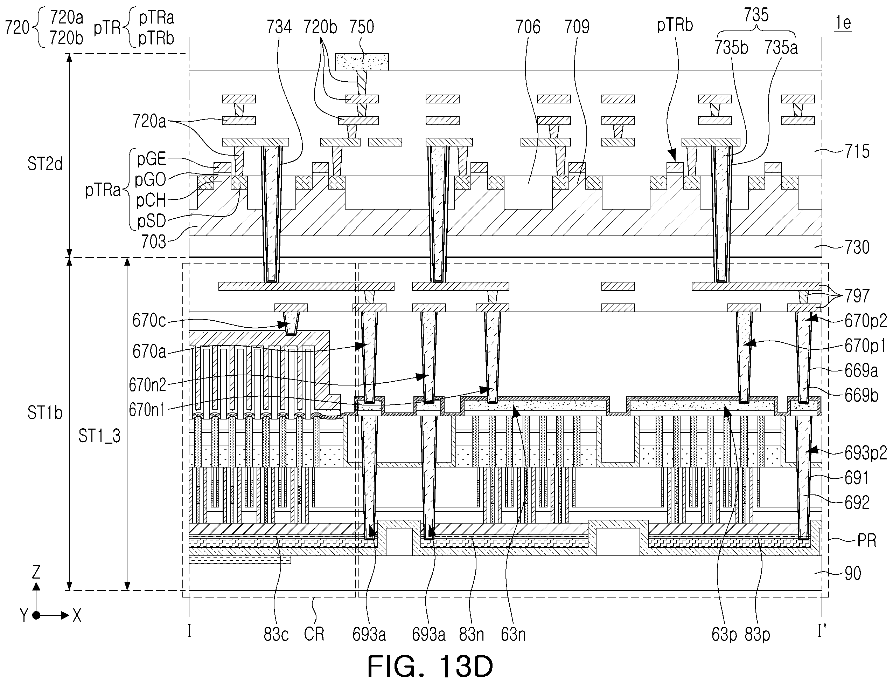

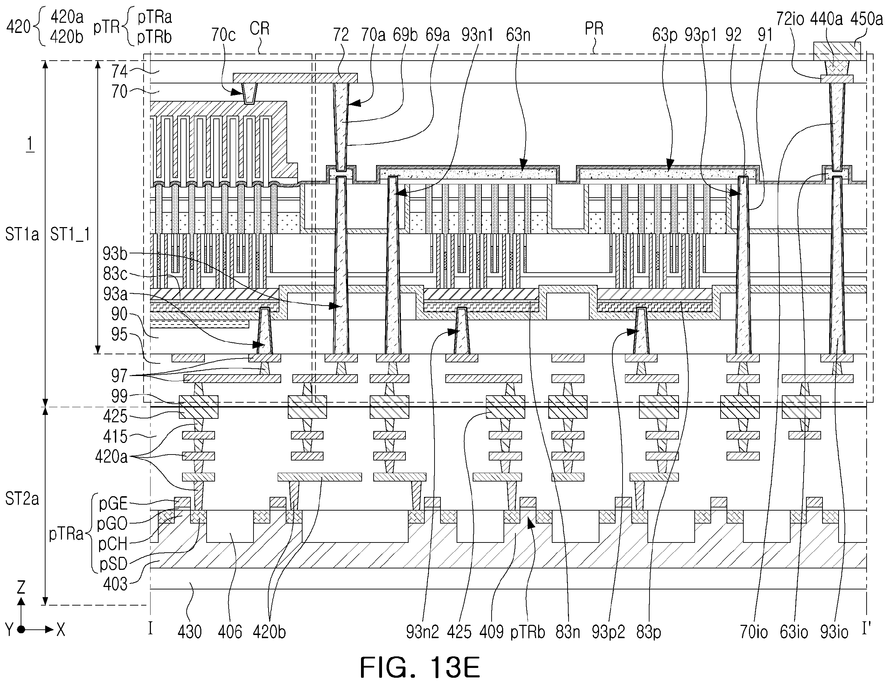

In the description below, various examples of the semiconductor device 1 described with reference to FIG. 1 will be described with reference to FIGS. 13A, 13B, 13C, 13D, and 13E. FIGS. 13A, 13B, 13C, 13D, and 13E are diagrams illustrating various examples of the semiconductor device 1 described with reference to FIG. 1.

In an example embodiment, referring to FIGS. 1 and 13A, the semiconductor device 1 may include a first structure ST1a corresponding to the first structure ST1 in FIG. 1 and a second structure ST2a corresponding to the second structure ST2 in FIG. 1. The second structure ST2a may be disposed below the first structure ST1a and may be bonded to and in contact with the first structure ST1a. The first structure ST1a may include a first portion ST1_1 the same as one of the first portions ST1_A and ST1_F described with reference to FIGS. 4 to 12B. For example, the first portion ST1_1 may be the same as the first portion ST1_A in FIG. 4. The first structure ST1a may further include an insulating layer 74 on the first portion ST1_1, and an insulating layer 95 below the first portion ST1_1. The first structure ST1a may further include upper contact plugs 70a and 70c and an upper interconnection 72. Each of the upper contact plugs 70a may include a conductive plug pattern 69b and a conductive liner 69a covering a side surface and a lower surface of the conductive plug pattern 69b. The upper contact plugs 70a and 70c may include a cell contact plug 70c penetrating the insulating layer 70 and connected to the second electrode 68c, and a connection contact plug 70a penetrating the insulating layer 70 and the insulating liner 66 and connected to the pad pattern 63a. The upper interconnection 72 may be connected to the contact plugs 70a and 70c and the insulating layer 70 on the contact plugs 70a and 70c and the insulating layer 70. The insulating layer 74 may be disposed on the insulating layer 70 and the upper interconnection 72. The first structure ST1a may further include lower contact plugs 93b, 93a, 93n1, 93n2, 93p2, and 93p1 extending upwardly and penetrating the insulating layer 90. Each of the lower contact plugs 93b, 93a, 93n1, 93n2, 93p2, and 93p1 may include a conductive plug pattern 92 and a conductive liner 91 covering a lower surface and a side surface of the conductive plug pattern 92. The lower contact plugs 93b, 93a, 93n1, 93n2, 93p2, and 93p1 may include a contact plug 93a connected to and in contact with the bit line 83c, a contact plug 93b connected to and in contact with the pad pattern 63a, a contact plug 93n1 connected to and in contact with the first upper interconnection 63n, a contact plug 93n2 connected to and in contact with the first lower interconnection 83n, a contact plug 93p2 connected to and in contact with the second lower interconnection 83p, and a contact plug 93p1 connected to and in contact with the second upper interconnection 63p. The first structure ST1a may form an insulating layer 95 disposed below the first portion ST_1, a routing interconnection structure 97 electrically connected to the lower contact plugs 93b, 93a, 93n1, 93n2, 93p2, and 93p1, and bonding pads 99 connected to the routing interconnection structure 97 in the insulating layer 95. A lower surface of the insulating layer 95 and lower surfaces of the bonding pads 99 may be coplanar with each other.

The second structure ST2a may include a first peripheral circuit pTRa vertically overlapping the memory region CR and a second peripheral circuit pTRb vertically overlapping the peripheral region PR. The second structure ST2a may include a substrate 403 and a device isolation region 406 defining active regions 409 on the substrate 403. The substrate 403 may be a semiconductor substrate. The first and second peripheral circuits pTRa and pTRb may be disposed on the substrate 403. Each of the first and second peripheral circuits pTRa and pTRb may include peripheral gate structures pGO and pGE disposed on the active region 409, peripheral source/drain regions pSD disposed in the active region 409 positioned on both sides of the peripheral gate structure pGO and pGE, and a peripheral channel region pCH between the peripheral source/drain regions pSD. The peripheral gate structure pGO and pGE may include a peripheral gate dielectric layer pGO and a peripheral gate electrode pGE sequentially stacked. The first and second peripheral circuits pTRa and pTRb may include a first peripheral circuit transistor pTRa vertically overlapping the memory region CR and a second peripheral circuit transistor pTRb vertically overlapping the peripheral region PR. The second structure ST2a may further include a lower routing interconnection structure 420 disposed on the substrate 403 and electrically connected to the first and second peripheral circuits pTRa and pTRb, second bonding pads 425 disposed on the lower routing interconnection structure 420, and a lower insulating structure 415. The lower insulating structure 415 may be disposed on the substrate 403 and may have an upper surface coplanar with upper surfaces of the second bonding pads 425. The upper surfaces of the second bonding pads 425 may be bonded to the lower surfaces of the first bonding pads 99, and the upper surface of the lower insulating structure 415 may be bonded to the lower surface of the insulating layer 95. The lower routing interconnection structure 420 may include a first lower routing interconnection structure 420a electrically connected to the second bonding pads 425 and a second lower routing interconnection structure 420b not directly connected to the second bonding pads 425. The second structure ST2a may further include an insulating layer 430 disposed below the substrate 403, a conductive through-via 440 penetrating the insulating layer 430 and the substrate 403 and connected to the second lower routing interconnection structure 420b, an insulating spacer 435 disposed on a side surface of the conductive through-via 440, and an input/output pad 450 connected to the conductive through-via 440 below the insulating layer 430.

In an example embodiment, referring to FIGS. 1 and 13B, the first bonding pads 99 in the first structure ST1a in FIG. 13A may not be provided. The second structure ST2a in FIG. 13A may be replaced with the second structure ST2b in FIG. 13B.

The second structure ST2b may include a first peripheral circuit pTRa vertically overlapping the memory region CR and a second peripheral circuit pTRb vertically overlapping the peripheral region PR. The second structure ST2b may include a first peripheral circuit pTRa vertically overlapping the memory region CR and a second peripheral circuit pTRb vertically overlapping the peripheral region PR. The second structure ST2b may include a substrate 503 and a device isolation region 506 defining active regions 509 below the substrate 503. The substrate 503 may be a semiconductor substrate. The first and second peripheral circuits pTRa and pTRb may be disposed below the substrate 503. Each of the first and second peripheral circuits pTRa and pTRb may include peripheral gate structures pGO and pGE disposed below the active region 509, peripheral source/drain regions pSD disposed in the active region 509 positioned on both sides of the peripheral gate structure pGO and pGE, and a peripheral channel region pCH between the peripheral source/drain regions pSD. The peripheral gate structure pGO and pGE may include a peripheral gate dielectric layer pGO and a peripheral gate electrode pGE sequentially stacked downwardly.

The second structure ST2b may further include a lower routing interconnection structure 520 disposed below the substrate 503 and electrically connected to the first and second peripheral circuits pTRa and pTRb, and a lower insulating structure 515 covering the lower routing interconnection structure 520 below the lower routing interconnection structure 520.

The lower routing interconnection structure 520 may include a first lower routing interconnection structure 520a and a second lower routing interconnection structure 520b. The second structure ST2b may further include an input/output pad 550 disposed below the lower insulating structure 515 and electrically connected to the second lower routing interconnection structure 520b, and an insulating layer 530 disposed between the substrate 503 and the first structure ST1a. The insulating layer 530 and the insulating layer 95 may be bonded to each other.

The first and second structures ST1a and ST2b may further include conductive through-vias 535 electrically connected to the first lower routing interconnection structure 520a, extending in the vertical direction Z, penetrating the substrate 503 and the insulating layer 530, and in contact with the routing interconnection structure 97, and insulating spacers 534 on side surfaces of the conductive through-vias 535. The conductive through-vias 535 may include a conductive pillar 535a and a conductive liner layer 535b covering a side surface and an upper surface of the conductive pillar 535a. Accordingly, a semiconductor device 1b including the first structure ST1a and the second structure ST2b may be provided.

In an example embodiment, referring to FIGS. 1 and 13C, a semiconductor device 1d according to an example embodiment may include a first structure ST1a corresponding to the first structure ST1 in FIG. 1 and a second structure ST2c corresponding to the second structure ST2 in FIG. 1. The second structure ST2c may be disposed on the first structure ST1a and bonded to and in contact with the first structure ST1a. The first structure ST1a may include a first portion ST1_3 the same as one of the first portions ST1_A and ST1_F described with reference to FIGS. 4 to 12B. For example, the first portion ST1_3 may be the same as the first portion ST1_A in FIG. 4. The first structure ST1a may further include an insulating layer 662 on the first portion ST1_1, and first bonding pads 625 electrically connected to the routing interconnection structure 660 and the routing interconnection structure 660 in the insulating layer 662. Upper surfaces of the first bonding pads 625 may be coplanar with an upper surface of the insulating layer 662. The pad pattern 63a described above may include a first pad pattern 63a1 vertically overlapping the bit line 83c, a second pad pattern 63a2 vertically overlapping the first lower interconnection 83n, and a third pad pattern 63a3 vertically overlapping the second lower interconnection 83p.

The first structure ST1a may further include lower contact plugs 693a, 693n2, and 693p2 and upper contact plugs 670c, 670a, 670n2, 670n1, 670p1, and 670p2. The lower contact plugs 693a, 693n2, and 693p2 may include a contact plug 693a extending between the bit line 83c and the first pad pattern 63a1 and electrically connecting the bit line 83c to the first pad pattern 63a1, a contact plug 693n2 extending between the first lower interconnection 83n and the second pad pattern 63a2 and electrically connecting the first lower interconnection 83n to the second pad pattern 63a2, and a contact plug 693p2 extending between the second lower interconnection 83p and the third pad pattern 63a3 and electrically connecting the second lower interconnection 83p to the third pad pattern 63a3. Each of the lower contact plugs 693a, 693n2, and 693p2 may include a plug pattern 692 and a conductive liner 691 covering side surfaces and lower surfaces of the plug pattern 692. The upper contact plugs 670c, 670a, 670n2, 670n1, 670p1, and 670p2 may include a contact plug 670c connected to the second electrode 68c, a contact plug 670a connected to the first pad pattern 63a1, a contact plug 670n2 connected to the second pad pattern 63a2, a contact plug 670p2 connected to the third pad pattern 63a3, a contact plug 670n1 connected to the first upper interconnection 63n1, and a contact plug 670p1 connected to the second upper interconnection 63p1. The upper contact plugs 670a, 670n2, 670n1, 670p1, and 670p2 may penetrate the insulating layer 70 and the insulating liner 66. The upper contact plug 670c may penetrate the insulating layer 70. The upper contact plugs 670c, 670a, 670n2, 670n1, 670p1, and 670p2 may be electrically connected to the routing interconnection structure 660.

The second structure ST2c may include a first peripheral circuit pTRa vertically overlapping the memory region CR and a second peripheral circuit pTRb vertically overlapping the peripheral region PR. The second structure ST2c may include a substrate 603 and a device isolation region 606 defining active regions 609 below the substrate 603. The substrate 603 may be a semiconductor substrate. The first and second peripheral circuits pTRa and pTRb may be disposed below the substrate 603. Each of the first and second peripheral circuits pTRa and pTRb may include peripheral gate structures pGO and pGE disposed below the active region 609, peripheral source/drain regions pSD disposed in the active region 609 positioned on both sides of the peripheral gate structure pGO and pGE, and a peripheral channel region pCH between the peripheral source/drain regions pSD. The peripheral gate structure pGO and pGE may include a peripheral gate dielectric layer pGO and a peripheral gate electrode pGE sequentially stacked downwardly. The second structure ST2c may further include a lower routing interconnection structure 620 disposed below the substrate 603 and electrically connected to the first and second peripheral circuits pTRa and pTRb, a lower insulating structure 615 covering the lower routing interconnection structure 620 below the lower routing interconnection structure 620, and second bonding pads 699 having a lower surface coplanar with a lower surface of the lower insulating structure 615. The second bonding pads 699 may be bonded to the first bonding pads 625, and the lower insulating structure 615 may be bonded to the insulating layer 662. The lower routing interconnection structure 620 may include a first lower routing interconnection structure 620a and a second lower routing interconnection structure 620b. The second structure ST2c may further include an insulating layer 630 on the substrate 603, an input/output pad 650 on the insulating layer 630, a conductive through-via 640 extending between the input/output pad 650 and the second lower routing interconnection structure 620b and electrically connecting the input/output pad 650 to the second lower routing interconnection structure 620b, and an insulating spacer 635 on a side surface of the conductive through-via 640. The conductive through-via 640 may penetrate the insulating layer 630 and the substrate 603.

In an example embodiment, referring to FIGS. 1 and 13D, the first bonding pads 625 in the first structure ST1a in FIG. 13C may not be provided. The second structure ST2c in FIG. 13C may be replaced with the second structure ST2d in FIG. 13D. The second structure ST2d may include a first peripheral circuit pTRa vertically overlapping the memory region CR and a second peripheral circuit pTRb vertically overlapping the peripheral region PR. The second structure ST2d may include a substrate 703 and a device isolation region 706 defining active regions 709 on the substrate 703. The substrate 703 may be a semiconductor substrate. The first and second peripheral circuits pTRa and pTRb may be disposed on the substrate 703.

Each of the first and second peripheral circuits pTRa and pTRb may include peripheral gate structures pGO and pGE disposed on the active region 709, peripheral source/drain regions pSD disposed in the active region 709 positioned on both sides of the peripheral gate structure pGO and pGE, and a peripheral channel region pCH between the peripheral source/drain regions pSD. The peripheral gate structure pGO and pGE may include a peripheral gate dielectric layer pGO and a peripheral gate electrode pGE sequentially stacked.

The second structure ST2d may further include a lower routing interconnection structure 720 disposed on the substrate 703 and electrically connected to the first and second peripheral circuits pTRa and pTRb, and a lower insulating structure 715 covering the lower routing interconnection structure 720 on the lower routing interconnection structure 720.

The lower routing interconnection structure 720 may include a first lower routing interconnection structure 720a and a second lower routing interconnection structure 720b. The second structure ST2d may further include an input/output pad 750 disposed on the lower insulating structure 715 and electrically connected to the second lower routing interconnection structure 720b, and an insulating layer 730 disposed between the substrate 703 and the first structure ST1b. The insulating layer 730 and the insulating layer 795 may be bonded to each other. The first and second structures ST1b, ST2d may further include conductive through-vias 735 electrically connected to the first lower routing interconnection structure 720a, extending downwardly, penetrating the substrate 703 and the insulating layer 730, and in contact with and connected to the routing interconnection structure 797, and insulating spacers 734 on side surfaces of the conductive through-vias 735. The conductive through-vias 735 may include a conductive pillar 735b and a conductive liner layer 735a covering a side surface and a lower surface of the conductive pillar 735b. Accordingly, a semiconductor device 1e including the first structure ST1b and the second structure ST2d may be provided.

In an example embodiment, referring to FIG. 1 and FIG. 13E, in the second structure ST2a in FIG. 13A, the conductive through-via (440 in FIG. 13A), the insulating spacer (435 in FIG. 13A), and the input/output pad (450 in FIG. 13A) may not be provided. Accordingly, the second structure ST2a in FIG. 13A may be modified as in FIG. 13E. The first structure ST1a may further include input and output lower contact plugs 93io formed simultaneously with the lower contact plugs 93b, 93a, 93n1, 93n2, 93p2, and 93p1. The first structure ST1a may further include an input and output conductive pattern 63io formed simultaneously with the conductive patterns 63a, 63n, 63p. The first structure ST1a may further include an input and output connection contact plug 70io formed simultaneously with the connection contact plug 70a, an input and output interconnection 72io formed simultaneously with the upper interconnection 72, a contact plug 440a on the input and output interconnection 72io, and an input and output pad 450a on the contact plug 440a. The input and output lower contact plug 93io, the input and output conductive pattern 63io, the input and output connection contact plug 70io, the input and output interconnection 72io, the contact plug 440a and the input and output pad 450a may be electrically connected to each other.

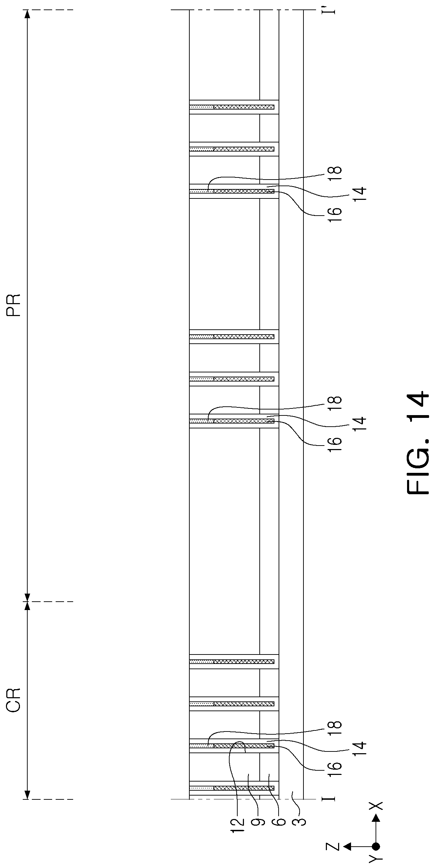

In the description below, an example of a method for forming a semiconductor device according to an example embodiment will be described with reference to FIGS. 14 to 23. FIGS. 14 to 23 are cross-sectional diagrams illustrating regions taken along line I-I' in FIG. 3 to describe an example of a method for forming a semiconductor device according to an example embodiment.

Referring to FIGS. 3 and 14, a sacrificial substrate 3, a sacrificial insulating layer 6, and a semiconductor layer 9 may be formed in order. The semiconductor layer 9 may be formed of a semiconductor material such as single crystal silicon. Trenches 12 penetrating the semiconductor layer 9 and the sacrificial insulating layer 6 may be formed. The trenches 12 may be formed in a memory region CR and a peripheral region PR. When viewed in cross-section in the X-Z plane (see, e.g., FIG. 14), each of the trenches 12 may have a line shape extending in the vertical direction Z. The semiconductor layer 9 may be divided by the trenches, and the divided regions of the semiconductor layer 9 may be spaced apart from each other in the first horizontal direction X. The method may include forming a back gate dielectric layer 14 conformally covering internal walls of the trenches 12, forming a back gate conductive layer on the back gate dielectric layer 14, forming preliminary back gate electrodes 16 partially filling the trenches 12 by etching a portion of the back gate conductive layer using an etch back process, and forming back gate capping insulating layers 18 filling the other portions of the trenches 12 on the preliminary back gate electrodes 16. The back gate capping insulating layers 18 may be formed of an insulating material.

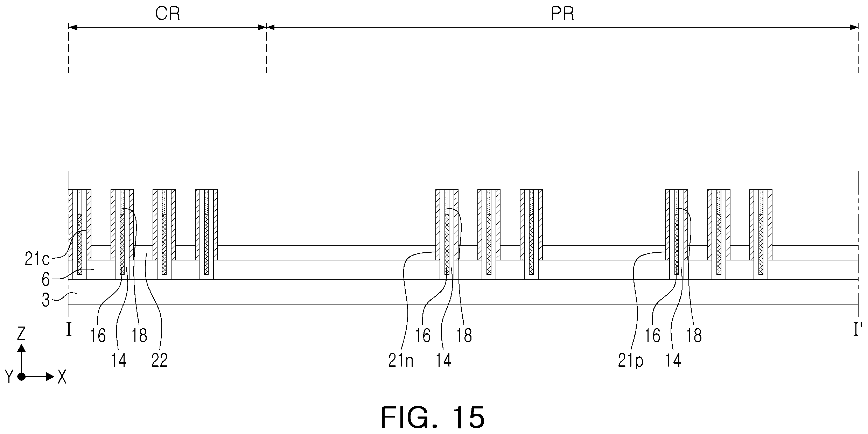

Referring to FIG. 3 and FIG. 15, vertical active patterns 21c, 21n, and 21p may be formed by patterning the semiconductor layers (9 in FIG. 14), and simultaneously, the sacrificial insulating layer 6 may be exposed. The vertical active patterns 21c, 21n, and 21p may include cell vertical active patterns 21c formed in the memory region CR, and first peripheral active patterns 21n and second peripheral active patterns 21p formed in the peripheral region PR. Among the vertical active patterns 21c, 21n, and 21c, a pair of adjacent vertical active patterns may be formed on both sides of one preliminary back gate electrode among the preliminary back gate electrodes 16. An insulating layer 22 may be formed on the exposed sacrificial insulating layer 6. The upper surface of the insulating layer 22 may be disposed at a level lower than a level of upper surfaces of the preliminary back gate electrodes 16.

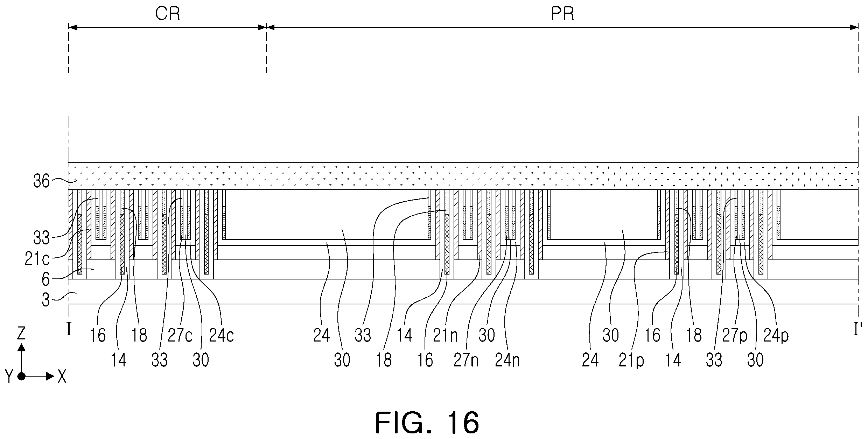

Referring to FIG. 3 and FIG. 16, dielectric layers 24c, 24, 24n, and 24p and gate electrodes 27c, 27n, and 27p may be formed. The forming the dielectric layers 24c, 24, 24n, and 24p and the gate electrodes 27c, 27n, and 27p may include forming a dielectric layer 24c, 24, 24n, and 24p conformally covering an upper surface of the insulating layer 22 and exposed side surfaces of the vertical active patterns 21c, 21n, 21c, forming a preliminary gate conductive layer conformally covering the gate dielectric layers 24c, 24, 24n, and 24p, by forming gate conductive layers by anisotropic etching the preliminary gate conductive layers, forming isolation insulating layers 30 on the gate conductive layers, forming gate electrodes 27c, 27n, and 27p by partially etching the gate conductive layers, and forming gate capping insulating layers 33 on the gate electrodes 27c, 27n, and 27p.

The dielectric layers 24c, 24, 24n, and 24p may include cell gate dielectric layers 24c, first peripheral gate dielectric layers 24n, second peripheral gate dielectric layers 24p, and a dielectric layer 24. The cell gate dielectric layers 24c may be in contact with side surfaces of the cell vertical active patterns 21c. The first peripheral gate dielectric layers 24n may be in contact with side surfaces of the first peripheral vertical active patterns 21n. The second peripheral gate dielectric layers 24p may be in contact with side surfaces of the second peripheral vertical active patterns 21p. The dielectric layer 24 may be disposed between adjacent groups among a group of the cell vertical active patterns 21c, a group of the first peripheral vertical active patterns 21n, and a group of the second peripheral vertical active patterns 21p.

The isolation insulating layers 30 may be disposed between the cell gate electrodes 27c adjacent to each other, between the first peripheral gate electrodes 27n adjacent to each other, between the second peripheral gate electrodes 27p adjacent to each other, and on the dielectric layer 24. Upper surfaces of the vertical active patterns 21c, 21n, and 21p, the isolation insulating layers 30, and the gate capping insulating layers 33 may be coplanar with each other. A first semiconductor layer 36 may be formed on the vertical active patterns 21c, 21n, and 21p, the isolation insulating layers 30, and the gate capping insulating layers 33. A lower surface of the first semiconductor layer 36 may be in contact with the upper surfaces of the vertical active patterns 21c, 21n, and 21p. The vertical active patterns 21c, 21n, and 21p may be formed of single crystal silicon. For example, the vertical active patterns 21c, 21n, and 21p may be formed of undoped single crystal silicon.

In an example, the first semiconductor layer 36 may be formed of polysilicon. For example, the first semiconductor layer 36 may be formed of undoped polysilicon.

In an example, the first semiconductor layer 36 may be formed of epitaxial silicon.

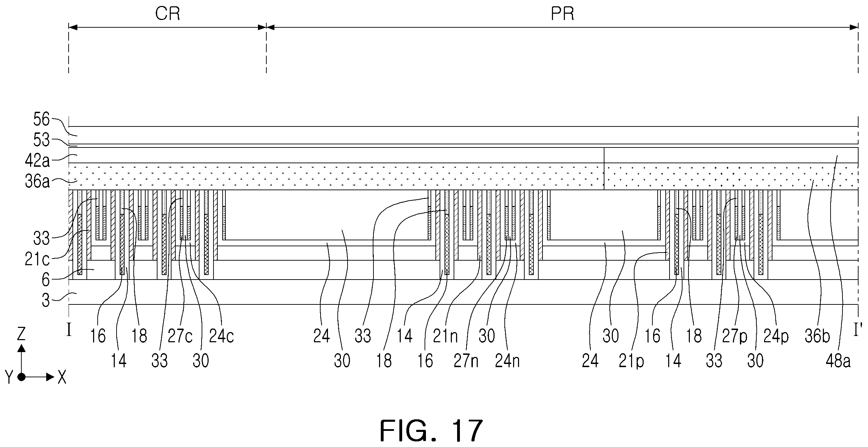

Referring to FIG. 3 and FIG. 17, a third semiconductor pattern 48a (e.g., a third semiconductor layer) and a second semiconductor pattern 42a (e.g., a second semiconductor layer) having different conductivity-types may be formed on the first semiconductor layer 36. The third semiconductor pattern 48a and the second semiconductor pattern 42a may have substantially the same thickness. The second semiconductor pattern 42a may vertically overlap the cell vertical active patterns 21c and the first peripheral vertical active patterns 21n. The third semiconductor pattern 48a may vertically overlap the second peripheral vertical active patterns 21p. The second semiconductor pattern 42a may have N-type conductivity, and the third semiconductor pattern 48a may have P-type conductivity. First impurities in the second semiconductor pattern 42a may diffuse into an upper region of the first semiconductor layer (36 in FIG. 16), the cell vertical active pattern 21c and the first peripheral vertical active pattern 21n. Accordingly, a concentration of impurities in the second semiconductor pattern 42a may be higher than a concentration of impurities in the first semiconductor layer 36, and a concentration of impurities in the first semiconductor layer 36 may be higher than a concentration of impurities in the upper region of the cell vertical active pattern 21c and the upper region of the first peripheral vertical active pattern 21n. The first impurities may be group V elements of the periodic table, for example, P or As. Second impurities in the third semiconductor pattern 48a may diffuse into an upper region of the first semiconductor layer (36 in FIG. 16) and the second peripheral vertical active pattern 21p. Accordingly, a concentration of impurities in the third semiconductor pattern 48a may be higher than a concentration of impurities in the first semiconductor layer 36, and a concentration of impurities in the first semiconductor layer 36 may be higher than the second concentration of impurities in the upper region of the second peripheral vertical active pattern 21p. The first impurities may be group III elements of the periodic table, for example, B or Al. The first semiconductor layer 36 may be formed of polysilicon doped with the group V element and the group III element. The first semiconductor layer 36 below the second semiconductor pattern 42a may be formed by the first semiconductor layer 36 doped with the first impurities, and the first semiconductor layer 36 below the third semiconductor pattern 48a may be formed by the first semiconductor layer 36b doped with the second impurities. A first conductive layer 53 and a second conductive layer 56 may be sequentially stacked on the second and third semiconductor patterns 42a and 48a. The first conductive layer 53 may include a first conductive material, and the second conductive layer 56 may include a second conductive material different from the first conductive material.

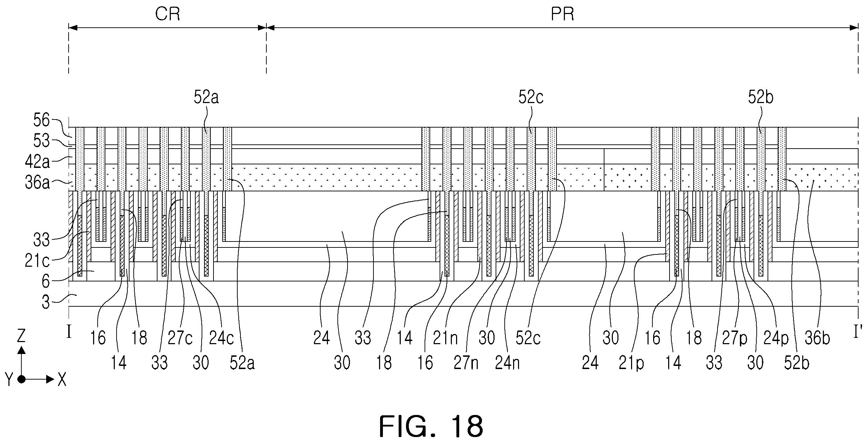

Referring to FIG. 3 and FIG. 18, isolation patterns 52a, 52b, and 52c may be formed. The isolation patterns 52a, 52b, and 52c may be formed of insulating nitride, for example, silicon nitride. The isolation patterns 52a, 52b, and 52c may include cell isolation patterns 52a, first peripheral isolation patterns 52c, and second peripheral isolation patterns 52b. The isolation patterns 52a, 52b, and 52c may be spaced apart from the vertical active patterns 21c, 21n, and 21p. The cell isolation patterns 52a may be formed in the memory region CR, and may penetrate the first conductive layer 53, the second conductive layer 56, the second semiconductor pattern 42a and the first semiconductor layer 36a. The first peripheral isolation patterns 52c may be formed in the peripheral region PR and may penetrate the first conductive layer 53, the second conductive layer 56, the second semiconductor pattern 42a and the first semiconductor layer 36a. The second peripheral isolation patterns 52b may be formed in the peripheral region PR and may penetrate the first conductive layer 53, the second conductive layer 56, the third semiconductor pattern 48a and the first semiconductor layer 36b.

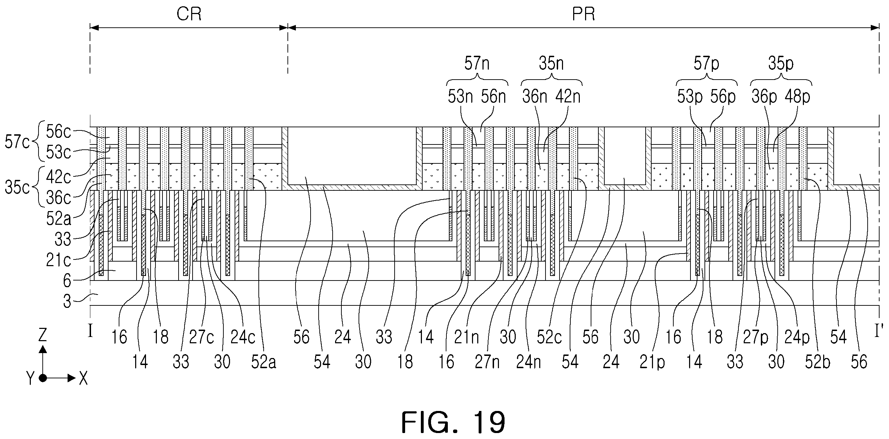

Referring to FIG. 3 and FIG. 19, insulating structures 54 and 56 may be formed. Each of the insulating structures 54 and 56 may be disposed between groups adjacent to each other among a group of the cell isolation patterns 52a, a group of the first peripheral isolation patterns 52c, and a group of a second peripheral isolation patterns 52b. The insulating structures 54 and 56 may penetrate the first conductive layer 53, the second conductive layer 56, the second and third semiconductor patterns 42a, 48a, and the first semiconductor layer 36a, 36b. Each of the insulating structures 54 and 56 may include an insulating pattern 56 and an insulating liner 54 covering a side surface and a lower surface of the insulating pattern 56. The insulating pattern 56 may include an oxide, and the insulating liner 54 may include a nitride. The first semiconductor layer 36a and the second semiconductor pattern 42a defined by the cell isolation patterns 52a may form cell lower source/drain layers 36c and cell upper source/drain layers 42c. The first semiconductor layer 36a and the second semiconductor pattern 42a defined by the first peripheral isolation patterns 52c may form first peripheral lower source/drain layers 36n and first peripheral upper source/drain layers 42n. The first semiconductor layer 36b and the third semiconductor pattern 48a defined by the second peripheral isolation patterns 52b may form second peripheral lower source/drain layers 36p and second peripheral upper source/drain layers 42p. The cell lower source/drain layer 36c and the cell upper source/drain layer 42c, sequentially stacked, may form a cell upper extended source/drain pattern 35c. The first peripheral lower source/drain layer 36n and the first peripheral upper source/drain layer 42n, sequentially stacked, may form a first peripheral upper extended source/drain pattern 35n. The second peripheral lower source/drain layer 36p and the second peripheral upper source/drain layer 48p, sequentially stacked, may form a second peripheral upper extended source/drain pattern 35p. The first and second conductive layers 53 and 56 defined by the isolation patterns 52a, 52b, and 52c may form contact plugs 57c, 57n, and 57p, respectively. The contact plugs 57c, 57n, and 57p may include cell contact plugs 57c formed on upper surfaces of the cell upper source/drain layers 42c, first peripheral upper contact plugs 57n formed on upper surfaces of the first peripheral upper source/drain layers 42n, and second peripheral upper contact plugs 57p formed on upper surfaces of the second peripheral upper source/drain layers 42p.

Each of the cell contact plugs 57c may include a cell lower conductive layer 53c in contact with an upper surface of the cell upper source/drain layer 42c, and a cell upper conductive layer 56c on the cell lower conductive layer 53c. Each of the first peripheral upper contact plugs 57n may include a first peripheral lower conductive layer 53n in contact with the upper surface of the first peripheral upper source/drain layer 42n, and a first peripheral upper conductive layer 56n on the first peripheral lower conductive layer 53n. Each of the second peripheral upper contact plugs 57p may include second peripheral lower conductive layer 53p in contact with the upper surface of the second peripheral upper source/drain layer 48p, and a second peripheral lower conductive layer 53p on the second peripheral upper conductive layer 56p.

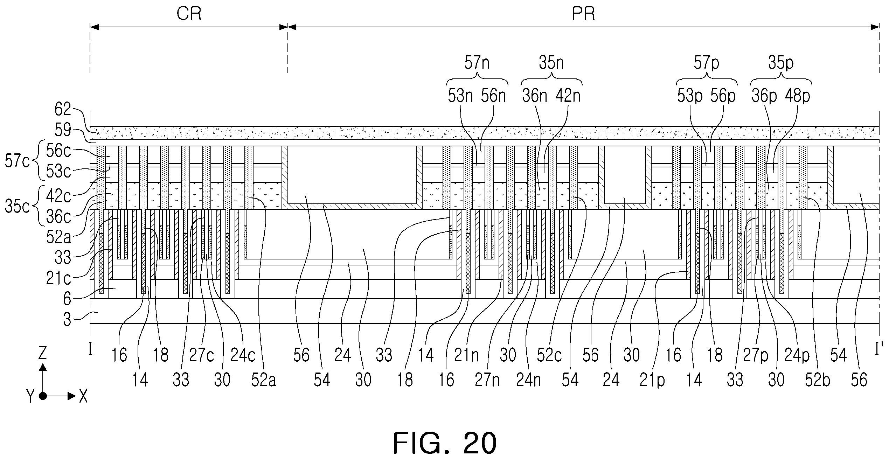

Referring to FIG. 3 and FIG. 20, conductive structures 59 and 62 may be formed on the contact plugs 57c, 57n, and 57p, the insulating structures 54 and 56, and the isolation patterns 52a, 52b, and 52c. The conductive structures 59 and 62 may include a first upper conductive layer 59 and a second upper conductive layer 62 sequentially stacked.

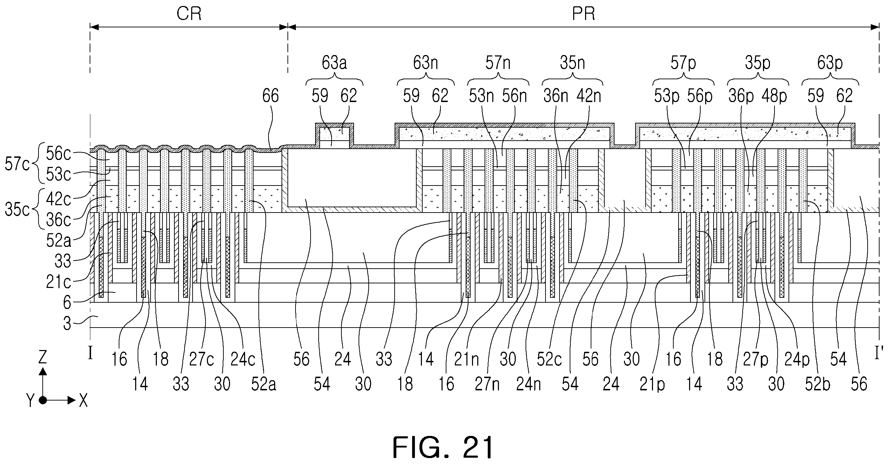

Referring to FIG. 3 and FIG. 21, conductive patterns 63a, 63n, and 63p may be formed by patterning the conductive structures 59 and 62. The conductive patterns 63a, 63n, and 63p may include a pad pattern 63a, a first upper interconnection 63n, and a second upper interconnection 63p. The first upper interconnection 63n may be connected to the first peripheral upper contact plugs 57n. The first upper interconnection 63n may be in contact with the upper surfaces of the first peripheral upper contact plugs 57n and the upper surface of the first peripheral isolation pattern 52c. The second upper interconnection 63p may be connected to the second peripheral upper contact plugs 57p. The second upper interconnection 63p may be in contact with upper surfaces of the second peripheral upper contact plugs 57p and an upper surface of the second peripheral isolation pattern 52b. The pad pattern 63a may be disposed on the insulating structure 54, 56. An insulating liner 66 covering upper surfaces and side surfaces of the conductive patterns 63a, 63n, and 63p in the peripheral region PR, and covering upper surfaces of the cell contact plugs 57c and the cell isolation pattern 52a in the memory region CR may be formed.

In the example embodiment, a conductive material of the upper region of the cell contact plug 57c may be different from a material of the conductive structure 59 and 62 adjacent to the peripheral upper contact plugs 57n and 57p. Accordingly, the cell contact plugs 57c may be prevented from being excessively etched while patterning the conductive structure 59 and 62.

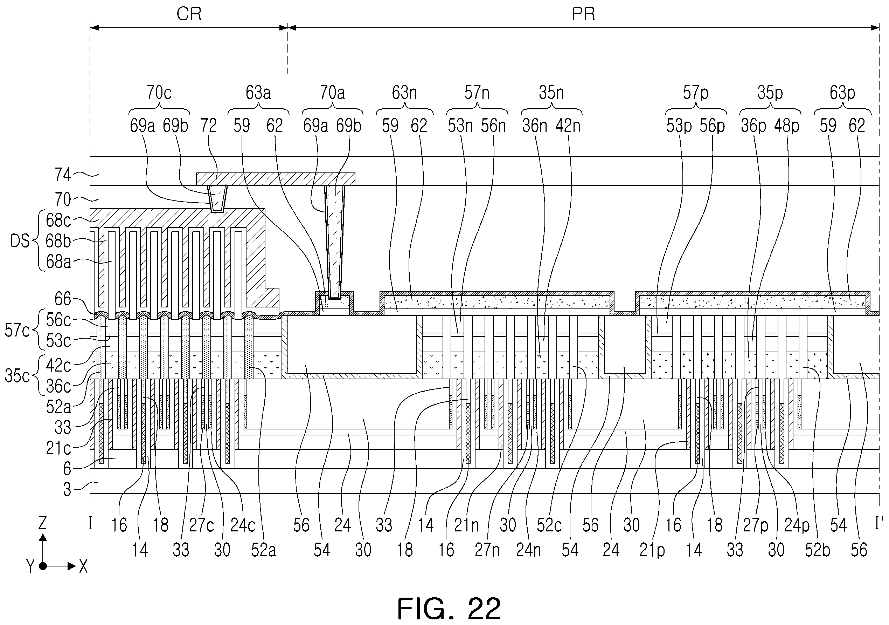

Referring to FIGS. 3 and 22, a data storage structure DS may be formed. The data storage structure DS may include first electrodes 68a connected to the cell contact plugs 57c, penetrating the insulating liner 66 and extending in the vertical direction Z, a second electrode 68c on each of the side surfaces and upper surfaces of the first electrodes 68a, and a dielectric layer 68b between the first electrodes 68a and the second electrode 68c. An insulating layer 70 covering the data storage structure DS in the memory region CR and the insulating liner 66 in the peripheral region PR may be formed. The insulating liner 66 may include a material different from a material of the insulating layer 70. Contact plugs 70a and 70c may be formed. Each of the contact plugs 70a may include a conductive plug pattern 69b and a conductive liner 69a covering a side surface and a lower surface of the conductive plug pattern 69b. The contact plugs 70a and 70c may include a cell contact plug 70c penetrating the insulating layer 70 and connected to the second electrode 68c, and a connection contact plug 70a penetrating the insulating layer 70 and the insulating liner 66 and connected to the pad pattern 63a. The upper interconnection 72 connected to the contact plugs 70a and 70c on the insulating layer 70 may be formed. The insulating layer 74 may be formed on the insulating layer 70 and the upper interconnection 72.

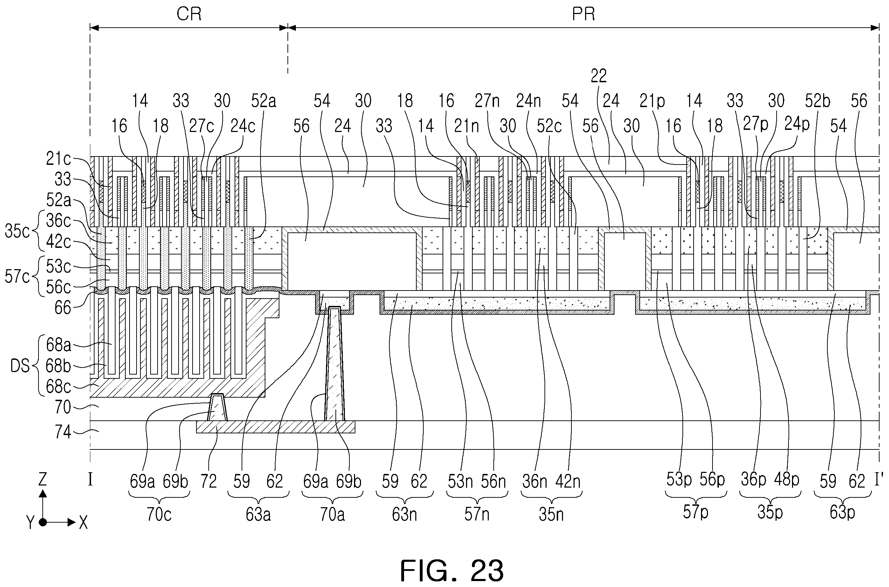

Referring to FIG. 3 and FIG. 23, the insulating layer 74 may be positioned in a downward direction, and the sacrificial substrate 3 and the sacrificial insulating layer 6 may be removed. Back gate electrodes 16c, 16n, and 16p may be formed by partially etching the preliminary back gate electrodes 16, and insulating layers 75 may be formed on the back gate electrodes 16c, 16n, and 16p. The insulating layer 22 and the vertical active patterns 21c, 21n, and 21p may be exposed.

Referring again to FIGS. 3 and 4, lower source/drain patterns 78c, 78n, and 79p and lower interconnection patterns 83c, 83n, and 83p vertically aligned may be formed. The lower source/drain patterns 78c, 78n, and 78p may include a cell lower source/drain pattern 78c connected to the cell vertical active patterns 21c, a first peripheral lower source/drain pattern 78n connected to the first peripheral vertical active patterns 21n and a second peripheral lower source/drain pattern 78p connected to the first peripheral vertical active patterns 21p. Impurities in the cell lower source/drain pattern 78c may diffuse into the cell vertical active patterns 21c such that source/drain regions may be formed in the cell vertical active patterns 21c. Impurities in the first peripheral lower source/drain pattern 78n may diffuse into the first peripheral vertical active patterns 21n, thereby forming source/drain regions in the first peripheral vertical active patterns 21n. Impurities in the second peripheral lower source/drain pattern 78p may diffuse into the second peripheral vertical active patterns 21p, thereby forming source/drain regions in the second peripheral vertical active patterns 21p. The lower interconnection patterns 83c, 83n, and 83p may include a bit line 83c in contact with and self-aligned with the cell lower source/drain pattern 78c, a first lower interconnection 83n in contact with and self-aligned with the first peripheral lower source/drain pattern 78n, and a second lower interconnection 83p in contact with and self-aligned with the second peripheral lower source/drain pattern 78p. Insulating structures 85 and 86 and a bit line shield structure 88 may be formed. The insulating structure 85 and 86 may include an insulating liner 85 covering an upper surface of the insulating pattern 86 and the insulating pattern 86, side surfaces of the lower source/drain patterns 78c, 78n, and 78p, and side surfaces and lower surfaces of the lower interconnection patterns 83c, 83n, and 83p. The bit line shield structure 88 may be disposed between the bit lines 83c and disposed below the bit lines 83c. The bit line shield structure 88 may be spaced apart from the bit lines 83c by the insulating liner 85. An insulating layer 90 may be formed on the insulating structure 85 and 86 and the bit line shield structure 88.

According to the aforementioned example embodiments, the transistor may include a lower source/drain, a vertical channel region, and an upper source/drain vertically aligned. The upper source/drain may include an upper source/drain region disposed in an upper region of a vertical active pattern and an extended upper source/drain pattern disposed on the vertical active pattern. The lower source/drain may include a lower source/drain region disposed in a lower region of the vertical active pattern and an extended lower source/drain pattern disposed below the vertical active pattern. Each of the extended lower and upper source/drain patterns may improve leakage current properties of the transistor. By including the lower and upper source/drain patterns in the transistor, performance of the transistor may be improved.

Also, a contact plug vertically aligned with the extended upper source/drain pattern and a lower interconnection vertically aligned with the lower source/drain may be provided. Accordingly, integration density of the semiconductor device may be improved.

Also, the conductive material of the region of the contact plug adjacent to the upper interconnection and the conductive material of the upper interconnection adjacent to the contact plug may be different from each other. Accordingly, the contact plug may be prevented from being excessively etched during the patterning process for forming the upper interconnection. Accordingly, reliability of the semiconductor device may be improved, and performance of the semiconductor device may be improved.

Also, by including the transistor, the contact plug, the upper interconnection, and the lower interconnection, the semiconductor device may have improved performance and improved integration density.

## Claims

1. A semiconductor device (1), comprising:
a cell vertical active pattern (21c) and a peripheral vertical active pattern (21n, 21p) disposed at the same vertical level;
a cell upper extended source/drain pattern (35c) and a cell contact plug (57c) sequentially stacked on the cell vertical active pattern (21c);
a peripheral upper extended source/drain pattern (35n, 35p) and a peripheral contact plug (57n, 57p) sequentially stacked on the peripheral vertical active pattern (21n, 21p);
a cell isolation pattern (52a) on a side surface of the cell upper extended source/drain pattern (35c) and a side surface of the cell contact plug (57c);
a peripheral isolation pattern (52b, 52c) on a side surface of the peripheral upper extended source/drain pattern (35n, 35p) and a side surface of the peripheral contact plug (57n, 57p); and
an upper interconnection (63n, 63p) on the peripheral contact plug (57n, 57p) and the peripheral isolation pattern (52b, 52c),
wherein a first distance between a vertical level of an upper end of the cell contact plug (57c) and a vertical level of an upper end of the cell isolation pattern (52a) is different from a second distance between a vertical level of an upper end of the peripheral contact plug (57n, 57p) and a vertical level of an upper end of the peripheral isolation pattern (52b, 52c).

2. The semiconductor device (1) of claim 1, wherein the first distance is greater than the second distance.

3. The semiconductor device (1) of claim 1 or 2, wherein an upper surface of the cell contact plug (57c) is disposed at a vertical level higher than a vertical level of an upper surface of the cell isolation pattern (52a).

4. The semiconductor device (1) of any one of the previous claims, wherein an upper surface of the cell contact plug (57c) is disposed at a vertical level lower than a vertical level of an upper surface of the cell isolation pattern (52a).

5. The semiconductor device (1) of any one of the previous claims,
wherein the cell contact plug (57c) includes a cell lower conductive layer (53c) and a cell upper conductive layer (56c) sequentially stacked,
wherein the peripheral contact plug (57n, 57p) includes a peripheral lower conductive layer (53n, 53p) and a peripheral upper conductive layer (56n, 56p) sequentially stacked,
wherein the cell lower conductive layer (53c) and the peripheral lower conductive layer (53n, 53p) have the same thickness and include the same first material, and
wherein the cell upper conductive layer (56c) and the peripheral upper conductive layer (56n, 56p) include the same second material.

6. The semiconductor device (1) of claim 5, wherein a thickness of the peripheral upper conductive layer (56n, 56p) is greater than a thickness of the cell upper conductive layer (56c).

7. The semiconductor device (1) of any one of the previous claims, wherein an upper surface of the cell isolation pattern (52a) is disposed at a vertical level lower than a vertical level of an upper surface of the peripheral isolation pattern (52b, 52c).

8. The semiconductor device (1) of any one of the previous claims, further comprising:
an insulating liner (66) covering an upper surface of the cell isolation pattern (52a), an upper surface of the cell contact plug (57c), a side surface of the upper interconnection (63n, 63p), and an upper surface of the upper interconnection (63n, 63p); and
a data storage structure including a first electrode (68a, 68a1), a second electrode (68c) and a dielectric layer (68b) between the first electrode (68a, 68a1) and the second electrode (68c),
wherein the first electrode (68a, 68a1) is connected to the cell contact plug (57c), penetrates the insulating liner (66) and extends upwardly.

9. The semiconductor device (1) of any one of the previous claims,
wherein the cell upper extended source/drain pattern (35c) includes a cell lower source/drain layer (36c) and a cell upper source/drain layer (42c) on the cell lower source/drain layer (36c), and
wherein the peripheral upper extended source/drain pattern (35n, 35p) includes a peripheral lower source/drain layer (36n, 36p) and a peripheral upper source/drain layer (42n, 42p) on the peripheral lower source/drain layer (36n, 36p).

10. The semiconductor device (1) of claim 9,
wherein the cell upper source/drain layer (42c) has a concentration of impurities higher than a concentration of impurities of the cell lower source/drain layer (36c), and
wherein the peripheral upper source/drain layer (42n, 42p) has a concentration of impurities higher than a concentration of impurities of the peripheral lower source/drain layer (36n, 36p).

11. The semiconductor device (1) of any one of the previous claims,
wherein the cell vertical active pattern (21c) includes a first cell source/drain region (21c_L), a second cell source/drain region (21c_U) on the first cell source/drain region (21c_L), and a cell channel region (21c_CH) between the first and second cell source/drain regions (21c_L, 21c_U), and
wherein the peripheral vertical active pattern (21n, 21p) includes a first peripheral source/drain region (21n_L, 21p_L), a second peripheral source/drain region (21n_U, 21p_U) on the first peripheral source/drain region (21n_L, 21p_L), and a peripheral channel region (21n_CH, 21p_CH) between the first and second peripheral source/drain regions (21n_L, 21p_L; 21n_U, 21p_U).

12. The semiconductor device (1) of claim 11, further comprising:
a cell lower extended source/drain pattern (78c) disposed below the cell vertical active pattern (21c) and connected to the first cell source/drain region (21c_L); and
a peripheral lower extended source/drain pattern (78n, 78p) disposed below the peripheral vertical active pattern (21n, 21p) and connected to the first peripheral source/drain region (21n_L, 21p_L).

13. The semiconductor device (1) of claim 12, further comprising:
a bit line (83c) aligned along a vertical direction with the cell lower extended source/drain pattern (78c) and below the cell lower extended source/drain pattern (78c); and
a lower interconnection (83n, 83p) aligned along the vertical direction with the peripheral lower extended source/drain pattern (78n, 78p) and below the peripheral lower extended source/drain pattern (78n, 78p).

14. The semiconductor device (1) of any one of claims 11 to 13, further comprising:
a cell gate (24c, 27c) facing a side surface of the cell channel region (21c_CH);
and
a peripheral gate (24n, 24p, 27n, 27p) facing a side surface of the peripheral channel region (21n_CH, 21p_CH).

15. A semiconductor device (1) of any one of the previous claims, wherein the cell contact plug (57c) includes a cell lower conductive layer (53c) and a cell upper conductive layer (56c) sequentially stacked,
wherein the peripheral contact plug (57n, 57p) includes a peripheral lower conductive layer (53n, 53p) and a peripheral upper conductive layer (56n, 56p) sequentially stacked,
wherein the cell lower conductive layer (53c) and the peripheral lower conductive layer (53n, 53p) include a first conductive material,
wherein the cell upper conductive layer (56c) and the peripheral upper conductive layer (56n, 56p) include a second conductive material different from the first conductive material,
wherein the upper interconnection (63n, 63p) includes a third conductive material different from the first conductive material and different from the second conductive material,
wherein the cell vertical active pattern (21c) and the peripheral vertical active pattern (21n, 21p) include single crystal silicon,
wherein each of the cell lower source/drain layer (36c) of the cell upper extended source/drain pattern (35c) and the peripheral lower source/drain layer (36n, 36p) of the peripheral upper extended source/drain pattern (35n, 35p) includes a first polysilicon layer, and
wherein each of the cell upper source/drain layer (42c) of the cell upper extended source/drain pattern (35c) and the peripheral upper source/drain layer (42n, 42p) of the peripheral upper extended source/drain pattern (35n, 35p) includes a second polysilicon layer.
